(19) Europäisches Patentamt / European Patent Office / Office européen des brevets

(11) **EP 1 636 610 B1**

(12) **EUROPÄISCHE PATENTSCHRIFT**

(45) Veröffentlichungstag und Bekanntmachung des Hinweises auf die Patenterteilung:
**03.12.2008   Patentblatt 2008/49**

(21) Anmeldenummer: **03717233.5**

(22) Anmeldetag: **25.03.2003**

(51) Int Cl.:
*G01S 17/08* (2006.01)          *H01L 27/146* (2006.01)

(86) Internationale Anmeldenummer:
**PCT/EP2003/003094**

(87) Internationale Veröffentlichungsnummer:
**WO 2004/086087 (07.10.2004 Gazette 2004/41)**

(54) **ERFASSUNG ELEKTROMAGNETISCHER STRAHLUNG**

DETECTION OF ELECTROMAGNETIC RADIATION

DETECTION D'UN RAYONNEMENT ELECTROMAGNETIQUE

(84) Benannte Vertragsstaaten:
**AT BE BG CH CY CZ DE DK EE ES FI FR GB GR HU IE IT LI LU MC NL PT RO SE SI SK TR**

(43) Veröffentlichungstag der Anmeldung:
**22.03.2006   Patentblatt 2006/12**

(73) Patentinhaber: **Thomson Licensing**
**92100 Boulogne (FR)**

(72) Erfinder:
 • **SCHREY, Olaf**
   **40878 Ratingen (DE)**
 • **JEREMIAS, Ralf**
   **48653 Coesfeld (DE)**
 • **BROCKHERDE, Werner**
   **47259 Duisburg (DE)**
 • **HOSTICKA, Bedrich**
   **45478 Mühlheim an der Ruhr (DE)**

(74) Vertreter: **Thies, Stephan**
**Deutsche Thomson OHG**
**European Patent Operations**
**Karl-Wiechert-Allee 74**
**30625 Hannover (DE)**

(56) Entgegenhaltungen:
**WO-A-02/33817          US-B1- 6 373 557**

 • **SCHWARTE R ET AL: "New electro-optical mixing and correlating sensor: facilities and applications of the photonic mixer device (PMD)" PROCEEDINGS OF THE SPIE, SPIE, BELLINGHAM, VA, US, Bd. 3100, 1997, Seiten 245-253, XP002080273 ISSN: 0277-786X**
 • **JEREMIAS R ET AL: "A CMOS photosensor array for 3D imaging using pulsed laser" 2001 IEEE INTERNATIONAL SOLID-STATE CIRCUITS CONFERENCE. DIGEST OF TECHNICAL PAPERS. ISSCC (CAT. NO.01CH37177), 2001 IEEE INTERNATIONAL SOLID-STATE CIRCUITS CONFERENCE. DIGEST OF TECHNICAL PAPERS, SAN FRANCISCO, CA, USA, 5-7 FEB. 2001, Seiten 252-253, 452, XP002265916 2001, Piscataway, NJ, USA, IEEE, USA ISBN: 0-7803-6608-5 in der Anmeldung erwähnt**
 • **SCHWARTE R: "Dynamic 3D-Vision" 2001 INTERNATIONAL SYMPOSIUM ON ELECTRON DEVICES FOR MICROWAVE AND OPTOELECTRONIC APPLICATIONS. EDMO 2001 (CAT. NO.01TH8567), 2001 INTERNATIONAL SYMPOSIUM ON ELECTRON DEVICES FOR MICROWAVE AND OPTOELECTRONIC APPLICATIONS. EDMO 2001, VIENNA, AUSTRIA, , Seiten 241-248, XP010570427 2001, Piscataway, NJ, USA, IEEE, USA ISBN: 0-7803-7049-X**

**Beschreibung**

Die vorliegende Erfindung bezieht sich auf die Erfassung elektromagnetischer Strahlung bzw. eine Empfängerstruktur hierfür und ist insbesondere für die zeitlich integrierende Erfassung mit variabler Empfindlichkeit geeignet, wie sie beispielsweise zur Erfassung von Informationen, wie z.B. der geometrischen Form, über ein Objekts mittels gepulster elektromagnetischer Strahlung verwendet werden können.

Die Anwendungen, in den elektromagnetische Strahlung mit variabler Empfindlichkeit erfasst werden soll, sind vielseitig. Ein CMOS-Kamera besteht beispielsweise aus einer Mehrzahl von Photoempfängern bzw. Pixeln, die in einem Array angeordnet sind. Der in Photodioden erzeugte Photostrom wird akkumuliert, indem eine vorgeladene Kapazität entladen wird. Die Akkumulation ist zumeist auf Akkumulationsfenster variabler Länge beschränkbar, um kürzer Belichtungszeiten zur Aufnahme von beispielsweise schnell beweglichen Objekten zu erzielen oder dergleichen. Die Beschränkbarkeit auf solche Zeitfenster wird erzielt, indem ein Schalter den ständigen Photostrom nur in den Akkumulationsfenstern mit der Kapazität koppelt. Nach jedem Akkumulationsfenster findet eine Auslese des Ladungszustands der Kapazität statt. Ein solcher CMOS-Empfänger ist beispielsweise in R. Jeremias, W. Brockherde, G. Doemens, B. Hosticka, L. Listl und P. Mengel "A COMS photosensor array for 3-D imaging using pulsed laser," Digest of Techn. Papers IEEE international Solid-State Circuits Conf. 2001, Febr. 6-7, 2001, San Francisco, S. 252-253 gezeigt. Das Dokument R. Schwarte et al., Proceedings of the SPIE, SPIE, Billingham, 1997, Seiten 245-253 beschreibt eine Vorrichtung zur Erfassung elektromagnetischer Strahlung. Das Dokument WO-A-02/33817 beschreibt eine Vorrichtung zur Erfassung von Signalwellen.

Solchel CMOS-Sensoren werden auch zur Erfassung von Objektinformationen mittels gepulster elektromagnetischer Strahlung verwendet. Sie bilden den Kern sogenannter 3D-Kameras bzw. 3D-Kamerasysteme, welche durch Aufnahme mit kurzer Belichtung dreidimensionale Abstandsbilder des aufgenommenen Objektes erzeugen können. Ein Beispiel eines solchen 3D-Sensors ist in der DE 19757595 A1 beschrieben. Fig. 6 soll das Messprinzip dieser 3D-Sensoren verdeutlichen. Verwendet wird ein optoelektronischer CMOS-Sensor 902, dessen Pixel wahlfrei auslesbar und dessen Integrationszeit pixelweise einstellbar ist. Eine Optik 904 bildet das zu vermessende Objekt 906 auf den Sensor 902 ab. Das Objekt 906 wird durch eine gepulste Lichtquelle 908 mit einem oder mehreren sehr kurzen Lichtimpulsen 910 beleuchtet, woraufhin Lichtimpulse der gleichen Länge von dem Objekt 906 zurückgestreut werden. Diese zurückgestreuten Lichteimpulse werden über die Optik 904 auf den CMOS-Sensor 902 geleitet.

Aufgrund der unterschiedlichen Abstände unterschiedlicher Objektpunkte zu dem Sensor 902 werden die mit diesen Objektpunkten korrespondierenden zurückgestreuten Lichtimpulse zu unterschiedlichen Zeiten am Sensor ankommen. Für eine Abstandsmessung wird an den Pixeln des Sensors 902 ein Zeitmess- bzw. Belichtungsfenster geöffnet, dessen Zeitdauer einer vorbestimmbaren Integrationszeit entspricht. Abstrahlzeiten und Integrationszeiten werden durch eine Steuereinrichtung 912 gesteuert und synchronisiert. Der erste in den Sensor 902 einfallende zurückgestreute Lichtimpuls wird bei Übereinstimmung der Integrationszeit mit der Abstrahlzeit in etwa mehr oder weniger vollständig aufgenommen werden. Die aufgrund des größeren Abstandes des Objektpunktes von dem Sensor 902 zeitverzögert eintreffenden Lichtimpulse werden nicht vollständig aufgenommen sondern hinten abgeschnitten. Auf diese Weise kann anhand der unterschiedlichen Ladungen, die während der Integrationszeit in den einzelnen Pixels des Sensors 902 gesammelt werden, die unterschiedlichen Laufzeiten und damit die Abstände des jeweiligen Pixels von seinem Objektpunkt bestimmt werden können. Hieraus lässt sich ein dreidimensionales Abstandsbild errechnen für die Steuer- bzw. Auswerteeinrichtung 912.

Anhand des obigen Messprinzips lässt sich folglich mittels einer CMOS-Bildsensorik Tiefe nichttaktil erfassen, indem extrem kurze Shutterzeiten mit Lichtpulslaufzeitverfahren unter Nutzung von beispielsweise Nah-Infrarot- (NIR-) Licht kombiniert werden, was dann zur Realisierung von dreidimensionalen (3D-) Kameras führt. Mit Hilfe von CMOS-Kamera lassen sich also nicht nur Kameras mit intelligenten Pixeln realisieren, die außer der Standardbildaufnahme auch die Präsens von Personen anhand von Bewegungen bestimmen oder dieselben sogar im Rahmen eines Trackings verfolgen können, sondern sie bieten ferner die Möglichkeit, optische Tiefenmessungen auf der Basis der NIR-Lichtlaufzeitmessung zu realisieren, entweder für bestimmte Bildbereiche oder ganze Bilder. Auf diese Weise sind also 3D-CMOS-Kameras realisierbar, die in der Lage sind, 2D- und 3D-Bildaufnahmen zu kombinieren.

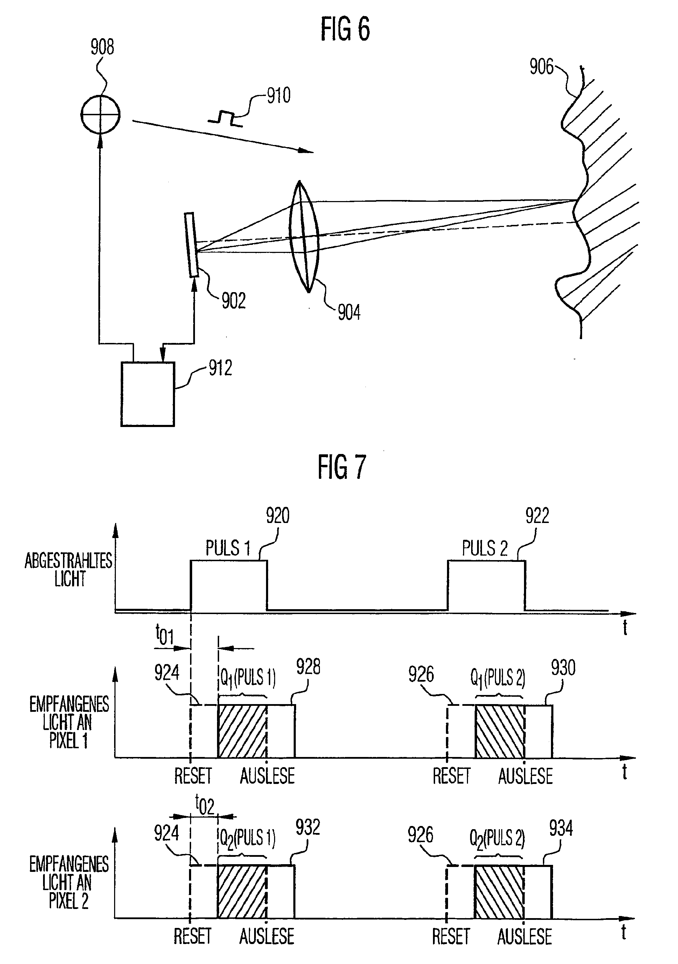

Mit dem Verfahren der 3D-Abstandsmessung mittels CMOS-Bildsensoren kommt der Anwender in die Lage, dreidimensionale Bildszenen elektronisch in Echtzeit verarbeiten zu können. Daraus ergibt sich eine Fülle von Anwendungsgebieten. Beispielsweise dreidimensionale Inspektions- und Plazierung- bzw. Placement-Systeme sind zur zuverlässigen Objekterkennung und Klassifizierung auf möglichst viele Bildinformationen angewiesen. In automotiven Systemen könnte die 3D-Abstandsmessung Überwachungsaufgaben übernehmen, wie z.B. die Kfz-Innenraumerkennung mit intelligenter Airbag-auslösung, Diebstahlsicherung, Fahrbahnerkennung und frühzeitige Unfallerkennung. Die 3D-Abstandsmessung könnte jedoch auch ganz einfach zur Topographievermessung, wie in Fig. 6 gezeigt, oder zur Personenerkennung oder als Präsenzsensorik verwendet werden. Speziell in der intelligenten Airbag-Auslösung muss beispielsweise vom Kamerasystem die Aufgabe gelöst werden, den Airbag in Abhängigkeit von dem Abstand des Fahrgasts mit verzögerter Stärke aufzulösen. Mit 3D-CMOS-Bildsensoren ist dies problemlos möglich. Seitens der Industrie besteht somit eine große Nachfrage nach solchen intelligenten Systemen, was wiederum ein erhebliches Marktpotential für 3D-Kameras bedeutet.

Existierende 3D-CMOS-Bildsensoren zur Abstand- bzw. Tiefenmessung, deren Messprinzip Bezug nehmend auf Fig. 6 beschrieben worden ist, basieren in weiten Teilen auf dem Funktionsprinzip des aktiven Pixel-Sensors (APS). Hierbei wird, wie oben beschrieben, die zeitliche Öffnung des Belichtungsfensters bzw. Integrationsfensters des Pixels mit der gepulsten Auflösung der aktiven Szenenbeleuchtung synchronisiert.

Um dies nun näher zu veranschaulichen, ist in Fig. 7 der Lichtintensitätsverlauf an der Lichtquelle 908 und an zwei exemplarischen Pixels des Sensors 902 in drei übereinander angeordneten Graphen dargestellt, deren x-Achse die Zeitachse darstellt und zueinander ausgerichtet sind, und deren y-Achse die Intensität des gepulsten reflektierten Lichts am Ort der Pixel in willkürlichen Einheiten bzw. das Vorhandensein desselben angibt. In dem obersten Graphen sind zwei aufeinanderfolgende abgestrahlte Lichtimpulse 920 und 922 dargestellt. Synchronisiert durch die Steuerung 912 wird gleichzeitig zu der Abstrahlung und mit derselben Zeitdauer ein Integrations- bzw. Belichtungsfenster in den Pixeln des Sensors 902 geöffnet, in denen der in denselben erzeugte Photostrom akkumuliert wird, wie es durch gestrichelte Linien in den unteren beiden Graphen 924 und 926 angezeigt ist, wobei der mittlere Graph das empfangene Licht an einen Pixel 1 und der untere Graph das empfangene Licht an einem anderen Pixel 2 anzeigt. In dem mittleren Graphen sind die beiden reflektierten Lichtpulse 928 und 930 zu erkennen, die sich auf die Pulse 920 und 922 hin am Pixel 1 ergeben. Wie es aus den unteren Graphen zu sehen ist, sind die reflektierten Lichtpulse 932 und 934 die sich an dem anderen Pixel 2 ergeben, erst nach einer größeren Laufzeitdifferenz $t_{D2}$ am Sensor 902 angelangt als die Laufzeitdauer $t_{D1}$ beim ersten Pixel 1. Die unterschiedliche Überlappung des reflektierten Lichtpulses an dem jeweiligen Pixel mit den Belichtungsfenstern 924 und 926 führt zu unterschiedlich akkumulierten Ladungen an den Pixeln, die an dem Ende jedes Belichtungsfensters 924 bzw. 926 ausgelesen werden. Insbesondere sind also die Ladungsmengen $Q_1$(Puls 1) und $Q_1$(Puls 2) an dem Pixel 1 größer als die Ladungsmengen $Q_2$(Puls 1) und $Q_2$ (Puls 2) an dem Pixel 2. Unmittelbar vor jedem Belichtungsfenster 924 und 926 findet ein Rücksetzen bzw. Reset des entsprechenden Pixels statt, bei welchem die Ladung des entsprechenden Pixels auf einen Referenzwert voreingestellt wird, bzw. bei welchem der der Photodiode des Pixels zugehörige Kondensator auf einen vorbestimmten Wert aufgeladen wird.

Wie im vorhergehenden Bezug nehmend auf Fig. 6 beschrieben, sollten sich aus den Ladungsmengen $Q_1$ bzw. $Q_2$, die ja den erzeugten Ladungsträgern aufgrund der reflektierten Lichtpulse entsprechen, die Abstände des entsprechenden Objektpunktes ermitteln lassen, der auf das jeweilige Pixel abgebildet wird, da ja die Ladungsmenge Q im Wesentlichen linear von der Laufzeitverzögerung $t_{D1}$ bzw. $t_{D2}$ und diese wiederum unter $2R/v_c$ von dem Abstand R abhängt, wobei $v_c$ die Lichtausbreitungsgeschwindigkeit im Ausbreitungsmedium bezeichne und bei Luft ungefähr der Lichtgeschwindigkeit c entspricht, so dass gilt:

$$Q \propto 2R/v_c \qquad\qquad \text{Gl. 1}$$

Verschiedene Probleme führen jedoch zu Abweichungen von der Theorie. So wird mit dem gewünschten Pulslicht auch immer ein Anteil unerwünschten Hintergrundlichtes mit erfasst. Außerdem beeinflusst auch die Reflektivität der Szenenobjekte den Anteil des rückgestrahlten Lichtes. Diese Faktoren verfälschen das Nutzsignal, nämlich die Ladungsmengen $Q_1$ bzw. $Q_2$, je nach Entfernung des Objektes zum Teil erheblich. Um unverfälschte Abstandsinformation zu erzielen, sind deshalb Korrekturmaßnahmen erforderlich. Die oben zitierte DE 19757595 A1 schlägt zur Normierung der Oberflächenreflexion die Durchführung zweier Aufnahmen vor, nämlich eine mit der oben beschriebenen kurzen Aufnahmezeit und eine weitere mit einer ausreichend langen Aufnahmezeit, um im Belichtungsfenster die reflektierten Pulse in ihrer Gesamtheit zu erfassen, wobei die Differenz beider Aufnahmen geteilt durch die Aufnahme mit langer Belichtung ein normiertes Abstandbild ergibt. Zur Hintergrundlichtunterdrückung wird vorgeschlagen, die zusätzlich zu den obigen Kurzzeit- und Langzeitmessungen jeweils eine weitere Kurzzeit- und Langzeitmessung durchzuführen, allerdings ohne Beleuchtung, und diese Aufnahmen von der jeweils noch vor Berechnung des normierten Abstandsbildes zugehörigen abzuziehen.

Für eine genügend hohe Genauigkeit wäre es aber zwingend erforderlich, ganze Pulssequenzen auf der Pixelstruktur zu akkumulieren bzw. integrieren, um ein brauchbares Signal-Rauschverhältnis zu erzielen. Nach jedem Puls der Pulssequenz bzw. jeder Akkumulationszeitdauer muss jedoch bisher jedes Pixel wieder rückgesetzt werden, d.h. dessen Kondensator durch Anlegen einer festen Betriebsspannung an Kondensator und Photodiode voll aufgeladen werden. Dieser Rücksetzvorgang erzeugt jedoch einen so erheblichen Rauschbeitrag, dass der durch die Mehrfachpulssequenz gewonnene Signalhub fast vollständig zunichte gemacht wird bzw. das Nutzsignal fast vollständig maskiert wird.

Die Aufgabe der vorliegenden Erfindung besteht darin, eine Vorrichtung und ein Verfahren zur Erfassung von elektromagnetischer Strahlung zu schaffen, so dass eine höhere Messgenauigkeit und/oder eine effektivere Erfassung bei gleicher Messgenauigkeit ermöglicht wird.

Diese Aufgabe wird durch eine Vorrichtung gemäß Anspruch 1 und ein Verfahren gemäß Anspruch 13 gelöst.

Der Kerngedanke der vorliegenden Erfindung besteht darin, dass das Rücksetzen des dem Empfänger zugeordneten Energiespeichers vor jedem Erfassungsintervall bzw. vor jeder Belichtungszeitdauer, während dessen die in dem Energiespeicher gespeicherte Energie gemäß dem Ausgangssignal des Empfängers verändert werden soll, um den Zustand des Energiespeichers nach dem Empfangsintervall als Informationen über das Objekt zu verwenden, vermieden werden kann, indem zwischen zwei Rücksetzereignissen die Empfindlichkeit des Empfängers, die die Höhe des Ausgangssignals bei fester elektromagnetischer Strahlung bestimmt, zumindest einmal höher und einmal niedriger eingestellt wird oder die Empfindlichkeit variiert wird. Der durch die Rücksetzvorgänge gelieferte Rauschbeitrag wird hierdurch vermieden, weshalb der Nutzen der Akkumulation bzw. Integration über mehrere Empfangsintervalle hinweg ohne diesen Rauschbeitrag genutzt werden kann.

Ein spezielles Ausführungsbeispiel der vorliegenden Erfindung bezieht sich auf die 3D-Abstands- bzw. Tiefenmessung. Ein zu vermessendes Objekt wird mit gepulsten Lichtstrahlen beleuchtet. Das so beleuchtete Objekt wird durch eine Optik auf ein Photodiodenarray abgebildet. Die Empfindlichkeit jeder Photodiode wird synchron zu der Lichtpulserzeugung erhöht bzw. erniedrigt, indem über eine Variation der Sperrspannung die Raumladungszone ausgedehnt bzw. verkleinert wird. Ein Schild deckt die Raumladungszone jeder Photodiode gegenüber den reflektierten Lichtpulsen bis zu einer Ausdehnung ab, die der Ausdehnung der Raumladungszone im Zustand geringer Ausdehnung entspricht, so dass in diesem Zustand lediglich der Diffusionsstrom zum Photostrom beiträgt. Der Photostrom jeder Photodiode entlädt einen zugeordneten Kondensator als Energiespeicher. Da nur in den Taktzyklen, an denen die Raumladungszone über den Bereich des Schilds ausgedehnt ist, der Driftphotostrom zum Photostrom der Photodiode beiträgt, wird es hierdurch ermöglicht, in dem Kondensator mehrere Belichtungen an aufeinanderfolgenden Lichtpulsen unter Variation der Empfindlichkeit zu summieren bzw. zu akkumulieren, ohne den Kondensator zwischen jeder Belichtung rücksetzen zu müssen.

Zur Beseitigung des Einflusses von Hintergrundlicht auf den Photostrom des Empfängers und damit der Verfälschung der durch die Vorrichtung gelieferten Informationen über das Objekt werden gemäß einem weiteren Ausführungsbeispiel der vorliegenden Erfindung jeweils zwei Photodioden miteinander kombiniert, indem dieselben über jeweils einen zugeordneten Kondensator an einen verschiedenen von zwei Anschlüssen einer steuerbaren Spannungsquelle angeschlossen werden. Die Spannungsquelle sorgt durch Spannungsvariation für einen reziproken bzw. entgegengesetzten Wechsel zwischen Erweiterung und Verkleinerung der Raumladungszone jeder der beiden Photodioden. Der Ein/Aus-Takt der Abstrahlung der Strahlungspulse ist in etwa frequenzgleich zu einem Takt, mit welchem die Raumladungsausdehnungsvariation durchgeführt wird. Auf diese Weise ändert sich die Differenzspannung zwischen den Spannungen an den beiden Kondensatoren in einem vollständigen Raumladungszonenvariationszyklus mit einer Zeitdauer einer hohen und einer Zeitdauer einer niedrigen Empfindlichkeit an beiden Photodioden um einen Wert, der nicht mehr von dem Hintergrundlicht abhängt und Informationen über die Entfernung des Objektpunktes liefert, der in etwa auf die beiden Pixel abgebildet wird.

Gemäß einem weiteren Ausführungsbeispiel der vorliegenden Erfindung sorgt die Steuereinrichtung zudem dafür, dass abwechselnd mit dem obigen Aufnahmemodus mit gleicher Abstrahl- bzw. Beleuchtungs- und Raumladungszonenvariations- bzw. Belichtungstaktfrequenz ein Reflektanzkorrekturmodus durchgeführt wird, bei welchem das Laserlicht zwar basierend auf dem gleichen Takt bzw. mit denselben Pulsdauern jedoch nur jedes zweite Mal abgestrahlt wird, während der Raumladungszonenvariationstakt im Vergleich zum Aufnahmemodus um die Hälfte reduziert bzw. verlangsamt wird. Laserabstrahlung und Raumladungszonenvariation werden wiederum synchronisiert, so dass jeder reflektierte Lichtpuls vollständig in einer Zeitdauer zu einem Photodiodenpaar gelangt, da die Raumladungszone der einen Photodiode groß und die der anderen klein ist. Der sich aus der Differenz der Kondensatorspannungen ergebende Wert nach einer oder mehreren vollständigen Raumladungszonenvariationszyklen kann als Maß für die Reflektanz des auf das Diodenpaar abgebildeten Objektpunktes und somit zur Korrektur der zu ermittelnden Objektentfernung verwendet werden, um ein normiertes Abstandbild zu erhalten.

Bevorzugte Ausführungsbeispiele der vorliegenden Erfindung werden nachfolgend Bezug nehmend auf die beiliegenden Zeichnungen näher erläutert. Es zeigen:

Fig. 1 eine schematische Darstellung eines Querschnitts einer Photodiode mit zugehöriger Beschaltung gemäß einem Ausführungsbeispiel der vorliegenden Erfindung;

Fig. 2 exemplarische Zeitverläufe gemäß einem Ausführungsbeispiel der vorliegenden Erfindung, die bei der Empfängerstruktur von Fig. 1 auftreten;

Fig. 3 eine schematische Darstellung eines Photodiodenpaars mit zugehöriger Beschaltung gemäß einem weiteren Ausführungsbeispiel der vorliegenden Erfindung;

Fig. 4     exemplarische Signalverläufe, die bei Verwendung des Photodiodenpaars von Fig. 3 bei Verwendung der Abstandsmessung gemäß dem Prinzip von Fig. 6 und 6 auftreten, gemäß einem Ausführungsbeispiel der vorliegenden Erfindung;

Fig. 5     exemplarische Signalverläufe, die bei dem Photodiodenpaar von Fig. 3 bei einem Reflektanzkorrekturmodus gemäß einem Ausführungsbeispiel der vorliegenden Erfindung auftreten;

Fig. 6     eine schematische Zeichnung zur Veranschaulichung des Prinzips der 3D-Abstandsvermessung mittels gepulster Beleuchtung und kurzer Belichtungszeit; und

Fig. 7     Zeitverläufe, die das Vorhandensein von Licht an der Lichtquelle und zwei unterschiedlichen Pixeln des Pixelsensors darstellen, zur Veranschaulichung der Verwirklichung des Messprinzips von Fig. 6 mit einem herkömmlichen CMOS-Sensor.

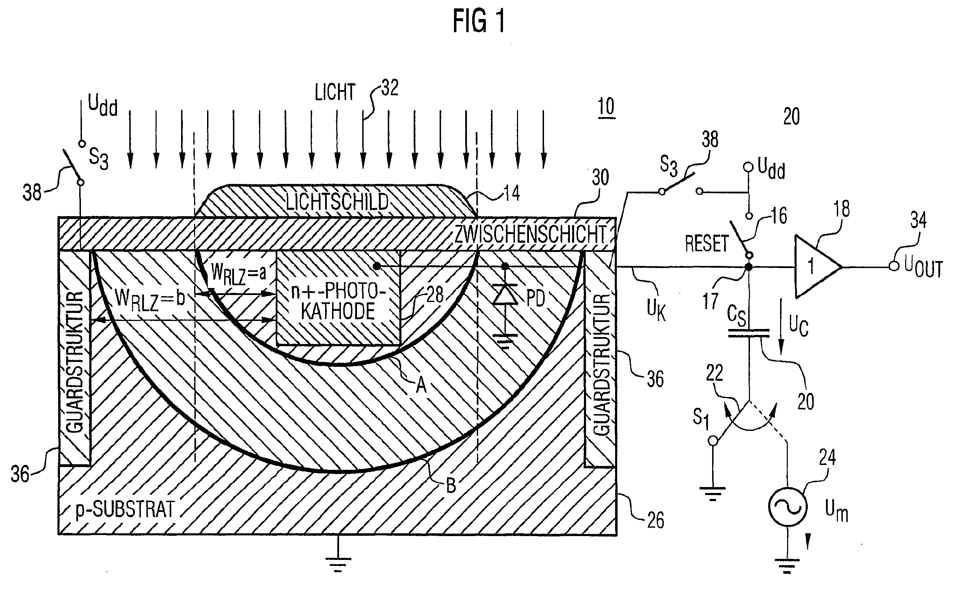

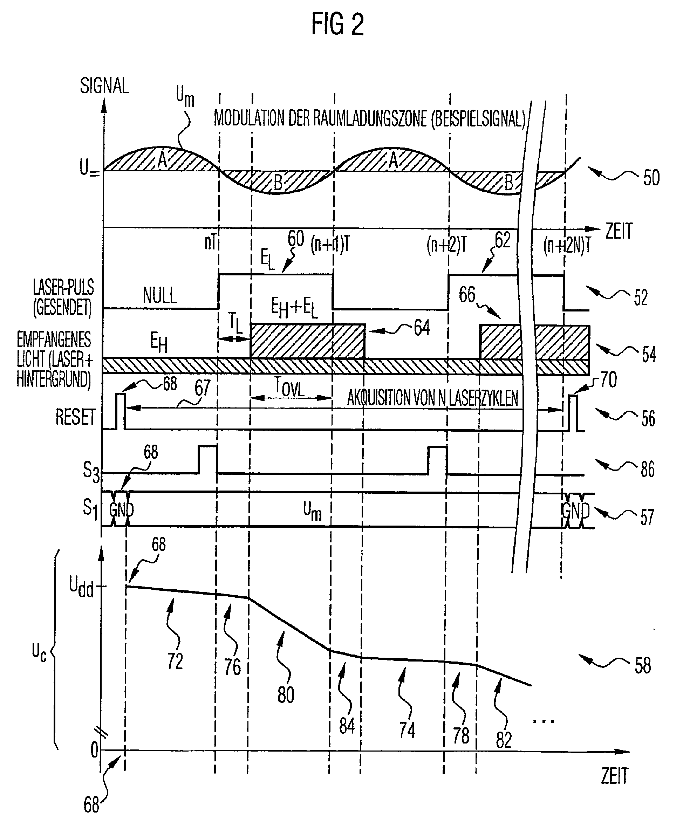

Die vorliegende Erfindung wird im folgenden Bezug nehmend auf die Fig. 1 anhand von Ausführungsbeispielen erläutert werden, die sich auf die Abstands- bzw. Tiefenmessung nach dem Prinzip von Fig. 6 bezieht. Im folgenden wird deswegen auch auf die Fig. 6 Bezug genommen werden, um die vorliegenden Erfindung dort einordnen zu können, wobei eine wiederholte Erläuterung von Fig. 6 weggelassen wird und in den folgenden Ausführungsbeispielen lediglich darauf hingewiesen wird, wo die in Fig. 1 bzw. 2 gezeigten Photodiodenstrukturen eingesetzt werden und welche Unterschiede sich ergeben.

Fig. 1 zeigt eine Photodiode mit zugehöriger Beschaltung gemäß einem Ausführungsbeispiel der vorliegenden Erfindung, wobei die dort gezeigte Struktur als ein Pixel in dem Sensor 902 verwendet wird. Genauer gesagt dient die Struktur 10 von Fig. 1 der Erfassung von von dem zu vermessenden Objekt 906 reflektierten Lichtpulsen, die sich als Reaktion auf die Lichtpulse 910 ergeben, mit denen das Objekt 906 durch die gepulste Lichtquelle 908 beleuchtet wird, wobei die Struktur 10 insbesondere die reflektierten Lichtpulse eines Objektspunktes erfasst, welche durch die Optik 904 auf einen lichtempfindlichen Bereich der Struktur 10 abgebildet wird, wie es im folgenden näher erörtert werden wird. Die Struktur 10 dient somit der Erfassung von Abstandsinformationen über den entsprechenden Objektpunkt des zu vermessenden Objektes 906.

Die Struktur 10 umfasst eine Photodiode 12, einen Lichtschild 14, einen Reset- bzw. Rücksetzschalter 16, einen 1-Verstärker 18, einen Kondensator 20 mit der Kapazität $C_s$, einen Schalter 22 sowie eine steuerbare Spannungsquelle 24. Die Photodiode 12 ist einmal im Querschnitt und ein anderes Mal schematisch mit PD angezeigt. Wie es der Querschnitt zeigt, ist die Photodiode 12 in einem p-Substrat, wie z.B. einem p-dotierten Si-Halbleitersubstrat, 26 gebildet, in welchem sich als Photokathode der Photodiode 12 ein n-dotierter Wannenbereich 28 befindet. An der Grenzfläche ergibt sich ein Halbleiter-pn-Übergang, in dem abhängig von der elektromagnetischen Strahlung Ladungsträger erzeugt werden können. An der Oberfläche des Substrates 26, an der die Photokathode 28 gebildet ist, ist eine Zwischenschicht 30 angeordnet. Die Zwischenschicht 30 trennt den sich oberhalb der Photokathode 28 befindlichen Lichtschild 14 von der Photokathode 28. Eine Guard- bzw. Abschirmungsstruktur 36, die über einen durch ein Signal S3 gesteuerten oder mehrer solcher Schalter 38 mit einer Versorgungsspannung $V_{dd}$ verbindbar ist und beispielsweise ein mit leitfähigem Material gefüllter Graben ist, trennt die Photodiode 12 von benachbarten Photodioden und umringt dieselbe, um in der Erholphase Störladungen abzusaugen bzw. zu $U_{dd}$ hin abzuleiten, wie es im folgenden noch näher erläutert werden wird.

Der Lichtschild 14 schirmt die Photokathode 28 gegen das von dem zu vermessenden Objekt 906 reflektierte Licht 32 oder allgemein gegen jegliches einfallendes Licht ab und ist lichtundurchlässig, während die Zwischenschicht 30 lichtdurchlässig ist. Die laterale Ausdehnung des Lichtschildes 14 entspricht einer lateralen Erstreckung einer Raumladungszone, wie sie sich einstellt, wenn sich die Photodiode 12 in einem Zustand geringer Empfindlichkeit befindet, wie es im folgenden noch näher erörtert werden wird, wobei die Erstreckung der Raumladungszone in diesem Fall in Fig. 1 mit "A" gezeigt ist. Bei höherer Empfindlichkeit erstreckt sich die Raumladungszone der Photodiode weiter, wobei ihre Erstreckung in diesem Zustand erhöhter Empfindlichkeit in Fig. 1 mit "B" angezeigt ist. Vorzugsweise befindet sich die Guardstruktur 36 zum Schutz vor Störladungen an der Stelle "B".

Die Photodiode 12 ist mit ihrer Anode bzw. über das p-Substrat auf Masse geschaltet. Die Kathode 28 der Photodiode 12 ist über den Schalter 16 mit einem Knoten 17 und von dort aus mit einer Versorgungsspannung $U_{dd}$, über einen 1-Verstärker 18 mit einem Ausgang 34 der Empfängerstruktur 10, an der die Ausgangsspannung $U_{out}$ anliegt, und über den Kondensator 20 mit dem Schalter 22 verbunden. Der Schalter 22 stellt entweder eine direkte Verbindung der Photodiode 12 mit Masse (durchgezogene Linie) als Bezugspotential oder eine Verbindung mit der steuerbaren Spannungsquelle 24 her, die zwischen Schalter 22 und Masse geschaltet ist.

Bezug nehmend auf Fig. 2 wird im folgenden die Funktionsweise der Empfängerstruktur von Fig. 1 erläutert, wenn dieselbe als ein Pixel in dem Array 902 des 3D-Sensors von Fig. 6 verwendet wird, wobei hierzu immer noch auf Fig. 1 und Fig. 6 Bezug genommen wird.

Fig. 2 zeigt untereinander exemplarische zeitliche Signalverläufe, wie sie gemäß einem Ausführungsbeispiel in der Empfängerstruktur 10 von Fig. 1 bei Verwendung in dem 3D-Sensor von Fig. 6 während eines Aufnahmemodus zur 3D-Vermessung auftreten. Entlang der x-Achse ist jeweils die Zeit aufgetragen. Entlang der y-Achse sind die nachfolgend bezeichneten Signalverläufe in willkürlichen Einheiten aufgetragen.

Ganz oben bei 50 ist der Signalverlauf der Spannung Um angezeigt, die von der gesteuerten Spannungsquelle 24 erzeugt wird. Wie es zu sehen ist, ist diese Spannung vorliegend exemplarisch eine sinusförmige Wechselspannung mit dem Gleichanteil $U_=$ und der Widerholzeitdauer 2T. Sie kann jedoch auch jede andere Form aufweisen, wie z.B. rechteckpulsartig sein. Insbesondere wird darauf hingewiesen, dass Fig. 2 von der vereinfachten Betrachtungsweise ausgeht, der Laser 908 könne das Licht beliebig modulieren. Tatsächlich beträgt üblicherweise der Laser-duty-cycle, d.h. der Arbeitszyklus bzw. das Verhältnis zwischen minimaler Pulsdauer und minimalem Widerholabstand der einzelnen Laserpulse aufgrund der Laser-Erholzeiten weit weniger als 50% (wie gezeigt), nämlich sogar weniger als 1 ‰. In diesem Fall wäre dies auch im duty-cycle des Modulationssignals Um zu berücksichtigen, d.h. $U_m$ variierte in kurzen Zeitdauern pulsartig mit einem großen dazwischenliegenden Wiederholabständen.

Darunter ist bei 52 der Pulsbetrieb der Lichtquelle 908 dargestellt, d.h. die an der Lichtquelle 908 abgestrahlte Energie aufgetragen über die Zeit, wobei die Energie in Sendezyklen $E_L$ und in Nicht-Sende-Zyklen Null beträgt. Sendezyklen bzw. Beleuchtungszyklen und Nicht-Sende-Zyklen wechseln sich ab und weisen beide eine Zeitdauer von T auf. Wie es zu erkennen ist, sind die durch die Spannungsquelle 24 erzeugte Spannung Um und die Intensität der gepulsten Lichtquelle 908, wie z.B. eines Lasers oder einer Laserdiode, in dem vorliegenden Ausführungsbeispiel gleichfrequent und gleichphasig zueinander. Die hierzu notwendige Synchronisation wird beispielsweise durch eine entsprechende Synchronisierungseinrichtung in der Steuerung 912 übernommen.

Bei 54 ist die empfangene Lichtenergie am Ort des Pixels bzw. der Empfangsstruktur 10 über die Zeit dargestellt. Wie es zu sehen ist, setzt sich die empfangene Lichtenergie aus der von Hintergrundlicht $E_H$ und aus der Energie der Lichtimpulse von der Lichtquelle 908 additiv zusammen, wie sie von dem Objekt 906 reflektiert worden sind und auf das Pixel 10 einfallen. Wie es zu sehen ist, benötigen die reflektierten Lichtimpulse, die mit 64 und 66 angezeigt sind, eine Zeitdauer $T_L$, bis sie die Empfangsstruktur 10 erreichen, wobei diese Zeitdauer dem Abstand des Objektspunktes des Objektes 906 entspricht, der durch die Optik 904 auf das Pixel 10 abgebildet wird, wie es bereits in der Beschreibungseinleitung beschrieben wurde. Die Impulsdauer der reflektierten Lichtpulse ist gleich der Pulsdauer der gesendeten Lichtpulse, d.h. der Zeitdauer T, die wiederum der Hälfte der Wiederholfrequenz 2T der Spannung $U_m$ bzw. des Lasers 908 entspricht. Wie es zu sehen ist, überlappen die Zeitdauern, in denen der Laser angeschaltet ist, mit den Zeitdauern, da die reflektierten Lichtpulse 64, 66 eintreffen, um eine Zeitdauer von $T_{OVL}$ miteinander.

Bei 56 und 57 ist das Zeitverhalten der Schaltzustände der Schalter 16 und 22 bzw. das Zeitverhalten der Ansteuerschaltsignale Reset bzw. $S_1$, mit denen dieselben angesteuert werden, dargestellt, wobei bei 16 ein hoher Zustand einen geschlossen Zustand und ein niedriger einen geöffneten Zustand anzeigt, und bei 17 die Schaltzustände durch "gnd" für auf Masse geschalteten Schalter 22 und durch "$U_m$" für zur Spannungsquelle 24 geschalteten Schalter 22 angedeutet sind. Beide Ansteuerschaltsignale Reset und $S_1$ werden von der Steuereinrichtung 902 gesteuert, die auch mit dem Ausgang 34 verbunden ist, um das Ausgangssignal $U_{out}$ wie im folgenden beschrieben auszuwerten, und zudem auch die steuerbare Spannungsquelle 24 steuert. Bei 58 ist exemplarisch das zeitliche Verhalten der Kondensatorspannung $U_c$ an dem Kondensator 20 dargestellt, auf das im folgenden noch näher eingegangen wird.

Im folgenden wird nun beschrieben, wie mittels der Empfängerstruktur 1 von Fig. 1 unter Verwendung des synchronisierten Betriebs zwischen Spannung Um und Laserbetrieb eine Integration mehrfacher Messungen des Überlapps zwischen Beleuchtungsfenstern 60 bzw. 62 einerseits und Empfangs- bzw. Belichtungsfenstern 64 bzw. 66 andererseits erzielt werden kann, ohne dabei den Kondensator 20 dazwischen zu entladen.

Wie es zu erkennen ist, wird zu Beginn eines Akquisitionszeitraumes 67 zur Akquisition von N Beleuchtungszyklen 64, 66 zunächst bei dem Zeitpunkt 68 durch Schließen des Schalters (16) und damit Schalten der einen Elektrode des Kondensators auf $U_{dd}$ und Schalten der anderen Elektrode des Kondensators 20 durch den Schalter 22 auf Masse (gnd) der Kondensator 20 auf die Versorgungsspannung $U_{dd}$ aufgeladen, wie es auch beim Signalverlauf 58 zu sehen ist. Unmittelbar danach wird der Reset-Schalter 16 wieder geöffnet und der Schalter 22 mit der Wechselspannungsquelle 24 verbunden. Dies bewirkt, dass nun die Spannung am Knoten 17 mit der Wechselspannung Um schwankt. Damit ändert sich auch die Sperrspannung über die Photodiode 12, so dass sich in Abhängigkeit von der Spannung Um auch die Ausdehnung $w_{RLZ}$ der Raumladungszone von $w_{RLZ} = a$ im Zustand geringer Empfindlichkeit A auf die Ausdehnung $w_{RLZ} = b$ im Zustand erhöhter Empfindlichkeit B ändert und umgekehrt, um zwischen denselben hin und her zu schwanken. Dieser Umstand ist bei 50 durch "B" und "A" veranschaulicht.

Wie es aus Fig. 1 hervorgeht, setzt sich der Photostrom, der den Kondensator 20 entlädt, im Zustand B hoher Empfindlichkeit additiv aus Diffusionsphotostrom und Driftphotostrom zusammen, wobei letztgenannter durch Elektron-Loch-Paare entsteht, welche durch Photonen erzeugt werden, die an dem Lichtschild 14 vorbei in denjenigen Teil der Raumladungszone eindringen, welcher die laterale Ausdehnung des Lichtschildes 14 überschreitet und dieselbe umgibt. Im Zustand geringerer Empfindlichkeit A erstreckt sich die Raumladungszone lediglich unterhalb des Lichtschildes 14, weshalb sich der Photostrom in diesem Zustand lediglich aus Diffusionsphotostrom zusammensetzt, da das Licht durch den Schild 14 daran gehindert wird in die Raumladungszone A einzudringen. Freilich nimmt die Raumladungszone abhängig von der sinusförmigen Spannung Um auch alle möglichen Zwischenzustände zwischen den Zuständen A und B ein und wird zwischen denselben Extremzuständen moduliert.

Durch die Modulation der Empfindlichkeit der Photodiode 12 wird der Akquisitionszyklus bzw. das Gesamtintegrationsintervall 67 zwischen dem ersten Rücksetzzeitpunkt 68 und einem daran anschließenden nächsten Rücksetzzeitpunkt 70 quasi in Belichtungszeitfenster B hoher Empfindlichkeit und Totzeitfenster A geringer Empfindlichkeit unterteilt. Die bei 58 dargestellte zeitliche Abhängigkeit der Spannung $U_c$ über den Kondensator 20 ist ein Maß für die Akkumulation der durch den Photostrom abgeführten Ladungen. In Zeiten 72 und 74, bei denen die Empfindlichkeit niedrig (Zustand A) ist und kein reflektierter Lichtpuls 64, 66 einfällt, fällt die Spannung $U_c$ lediglich aufgrund des durch das Hintergrundlicht erzeugten Diffusionsphotostroms, also sehr flach, ab. Zu Zeiten 76, 78 fällt die Spannung $U_c$ aufgrund Diffusions- und Driftphotostrom ab, wie er durch das Hintergrundlicht erzeugt wird, d.h. geringfügig schneller als in den Zeiten 72, 74. In Zeiten 80 und 82 wird die eigentlich zu vermessende Information erfasst, nämlich der Photostrom, zusammengesetzt aus Diffusions- und Driftphotostrom, wie er durch das reflektierte Laserlicht 64, 66 erzeugt wird. Daneben trägt aber auch der Photostrom, wiederum sowohl Drift- als auch Diffusionsphotostrom, zur Verringerung von $U_c$ bei, wie er durch das Hintergrundlicht erzeugt wird. In Zeiten 84, da die Empfindlichkeit gering (Zustand A) und der letzte Teil der reflektierten Lichtpulse einfällt, ist der Abfall von $U_c$ wiederum sehr gering, da lediglich der durch die reflektierten Lichtpulse und das Hintergrundlicht erzeugte Diffusionsphotostrom zur Entladung des Kondensators 20 beiträgt.

Wie es aus der vorhergehenden Beschreibung hervorgeht, wird folglich die eigentliche Information, die auf den Überlapp der reflektierten Lichtpulse mit den Beleuchtungsfenstern 60 und 62 bzw. auf die Laufzeit $T_L$ und damit schließlich auf die Entfernung des auf das jeweilige Pixel abgebildeten Objektpunktes schließen lässt, nämlich der durch $E_L$ bewirkte Photostrom in den Zeiten 80 und 82 akkumuliert und in den anderen Zeiten 72, 76, 84, 74, 78 kaum verfälscht, da in diesen Zeiten entweder die Empfindlichkeit stark verringert ist, oder lediglich Hintergrundlicht mit hoher Empfindlichkeit aufgenommen wird. Dieser Vorgang lässt sich für alle N Beleuchtungszyklen in der gesamten Integrationszeitdauer wiederholen, ohne dass die Photodiode 12 bzw. der zugehörige Kondensator 20 vor jedem neuen Laserpuls mittels des Reset-Schalters 16 rückgesetzt werden muss. Damit ist das in der Beschreibungseinleitung geschilderte Problem des Störrauschens, wie es durch das Rücksetzen erzeugt wird, gelindert, wobei dieses Prinzip der Empfindlichkeitsmodulation zwischen den Rücksetzzeitpunkten ferner auch bei anderen Messprinzipien vorteilhaft anwendbar sein kann, wie es am Ende der Figurenbeschreibung noch erwähnt werden wird.

Nach Beendigung einer Integrationszeitdauer 67 über N Beleuchtungszyklen wird kurz vor dem den nächsten Akquisitionszyklus beginnenden Reset-Zeitpunkt 70 das Ausgangssignal $U_{out}$ am Ausgang 34 durch die Steuereinrichtung 912 ausgewertet, wobei $U_{out} = U_c = U_m$ gilt. Der Wert von $U_{out}$ wird beispielsweise zu einem Zeitpunkten ausgewertet, da $U_m = U_=$ ist, so dass der Beitrag von $U_=$ konstant und bekannt ist, oder, alternativ, wird der Anteil von Um in $U_{out}$ auf sonstige Weise ermittelt, um aus $U_{out}$ $U_c$ zu erhalten. Wie aus dem Wert $U_c$ am Ende des Integrationszyklus auf die Entfernung zu dem auf das entsprechende Pixel abgebildeten Objektpunktes berechnet wird, geht exemplarisch aus den nachfolgenden Ausführungsbeispielen oder, alternativ, aus der Beschreibung bezug nehmend auf Fig. 6 und Fig. 7 in der Beschreibungseinleitung in Hinblick auf die Kurzzeitaufnahmen hervor.

Ferner ist in Fig. 2 bei 86 das Zeitverhalten der Schaltzustände des Schalters 38 bzw. das Zeitverhalten des Ansteuerschaltsignals $S_3$ gezeigt, wobei ein hoher Zustand einen geschlossen Zustand und ein niedriger einen geöffneten Zustand anzeigt. Das Signal $S_3$ bewirkt über den Schalter 38 ein periodisches Legen der Guardstruktur 36 kurz vor den Sendephasen 60, 62 des Lasers auf das Potential $V_{dd}$, und bewirkt damit, dass Ladungen, die sich während der in den Nichtsendephasen des Lasers aufgrund des Hintergrundlichtes angesammelt haben, im Bereich der Photodiode abgesaugt werden, um in den darauffolgenden Integrationszeitauern A ein möglichst unverfälschtes Ergebnis zu erhalten. Dies trägt wiederum dem Unstand Rechnung, dass aktuell auf dem Markt erhältliche Puls-laserquellen nicht in der Lage sind, Pulse in einem Zeitraster von ca. 60ns abzustrahlen, wie in etwa den Pulsdauern der einzelnen Sendepulse entspricht und die Modulation der Raumladungszone nach dem Beispiel von Fig. 2 verlangen würde, das ja von einem duty-cycle von 50% ausgeht. Wie erwähnt, können bisherige Laser nur im kHz-Bereich pulsen. Das entspricht wiederum langen Erholzeiten, d.h. Nicht-Sendephasen, in denen Hintergrundlicht auf die Photodiode 12 fällt. Zwar wird in diesem Fall, wie oben beschrieben, der duty-cycle der Raumladungszonenmodulation Um an den duty-cylce des Lasers angepasst, d.h. die A-Phase gegenüber B-Phase verlängert, damit die bereits aquirierten Ladungsträger auf der Photodiode 12 verbleiben, aber dennoch gelangen durch Diffusionseffekte durch das Hintergrund erzeugte gelangte Ladungen zur Photodiode und entladen diese, bis sie sättigt. Diese Störladungen werden durch die Guardstruktur 36 abgesaugt. Anstelle der beschriebenen Guardstruktur könnte freilich auch eine weitere Photodiode, ein Massering oder eine Kapazität verwendet werden. Ferner könnte ein anderes Schaltschema als das bei 86 gezeigte verwendet werden.

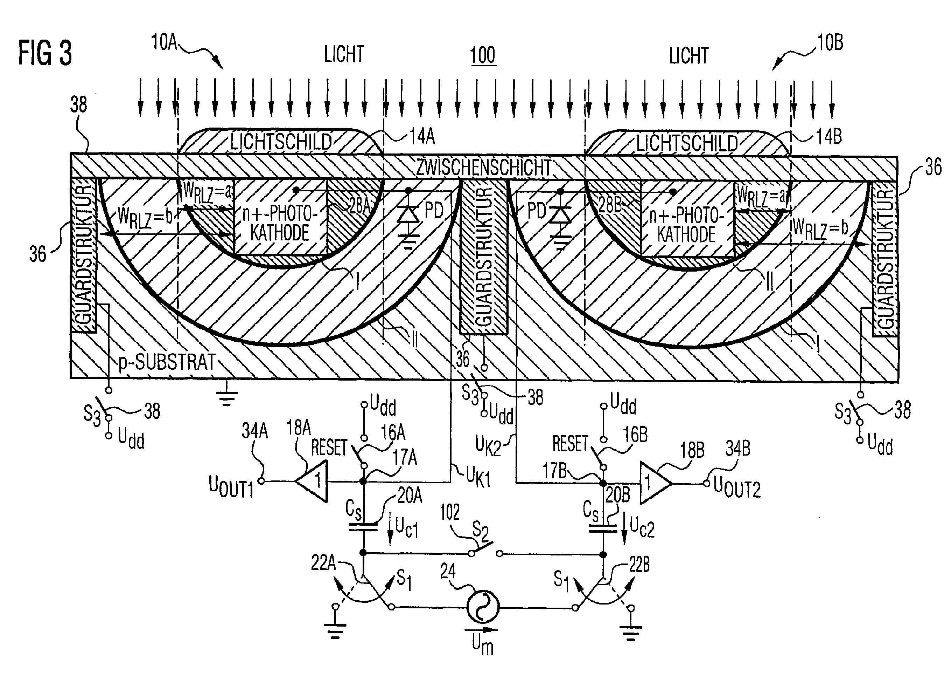

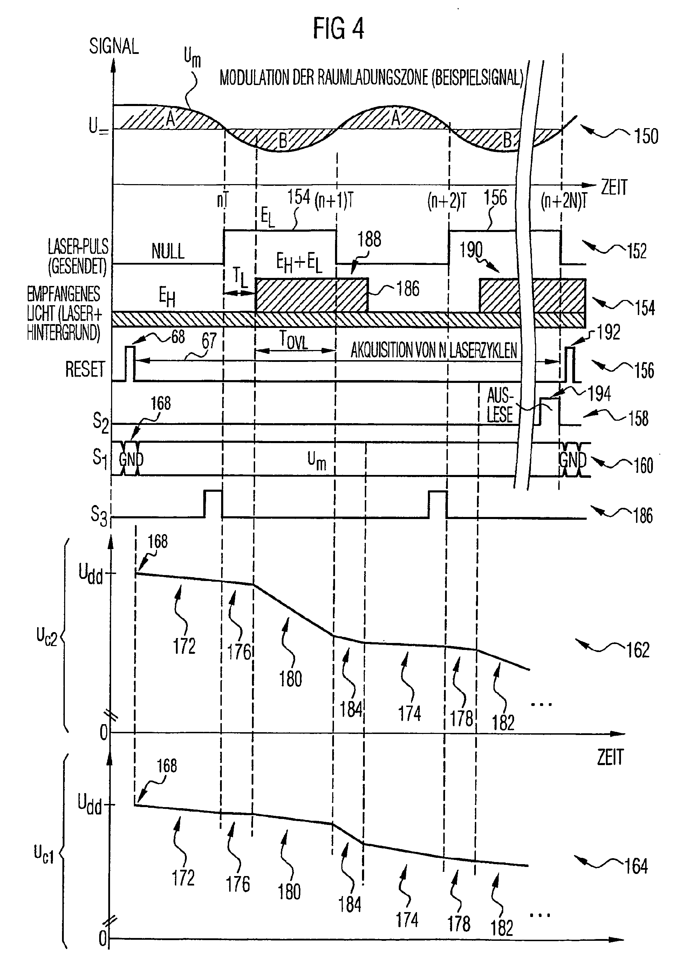

Bei dem bisherigen Ausführungsbeispiel von Fig. 1 und 2 wurde lediglich eine Photodiode für ein Pixel verwendet. Bei dem nachfolgenden Beispiel, welches Bezug nehmend auf die Fig. 3 und 4 beschrieben wird, werden zwei Photodioden miteinander in differentieller Technik kombiniert, um ein Pixel zu bilden, wobei dieses Ausführungsbeispiel gegenüber dem vorhergehenden den Vorteil aufweist, dass die Verfälschung des Nutzsignals durch das Hintergrundlicht verringert wird. Insbesondere wird durch Auswertung eines differentiell modulierten Signals Effekte eliminiert, wie aus den Gleichanteilen der Einzelsignale herrühren. Im Gegensatz zu dem 3D-Sensor der in der Beschreibungseinleitung beschriebenen DE 19757595 A1 sind keine reinen Belichtungsakquisitionszyklen notwendig, in welchen ohne Beleuchtung lediglich das Hintergrundlicht erfasst wird.

Fig. 3 zeigt allgemein mit 100 eine Empfängerstruktur, wie sie als ein Pixel in dem Pixelarray 902 des 3D-Sensors von Fig. 6 dienen kann. Die Empfängerstruktur von Fig. 3 entspricht im wesentlichen einer Verdopplung des Aufbaus von Fig. 1 und besteht aus einer Empfängerteilstruktur 10a und einer weiteren Empfängerteilstruktur 10b. Die Empfängerteilstruktur 10a und 10b sind im wesentlichen identisch zu der Empfängerstruktur von Fig. 1 und deren Bestandteile werden deshalb mit Bezugszeichen versehen, die sich von denjenigen aus Fig. 1 lediglich durch Index a bzw. b unterscheiden. Genauer ausgedrückt bestehen beide Empfängerstrukturen 10a bzw. 10b aus einer Photodiode 12a bzw. 12b, einem Lichtschild 14a, 14b, einer gemeinsamen, die beiden Photodioden 12a und 12b umgebende und dieselben voneinander Trennende Guardstruktur 36, welche in der Erholphase des Lasers Störladungen absaugt und über einen Schalter 38 gemäß einem Signal $S_3$ auf des Potential $V_{dd}$ schaltbar ist, einem Reset-Schalter 16a, 16b, die von einem gemeinsamen Reset-Signal gesteuert werden, einem Schaltungsknoten 17a, 17b, einem 1-Verstärker 18a, 18b, einem Kondensator 20a, 20b und einem Schalter 22a, 22b, die von einem gemeinsamen Signal $S_1$ gesteuert werden, wobei diese Elemente wie in Fig. 1 beschrieben verschaltet sind. Hinsichtlich der Guardstruktur 38 wird auf das bezugnehmend auf das vorhergehende Ausführungsbeispiel Gesagte verwiesen. Sie kann auch aus mehreren Abschrimfingern bestehen.

Beide Photodioden 12a und 12b sind in einem gemeinsamen p-Substrat 26 gebildet und umfassen einen n-dotierten Photokathodenbereich 28a, 28b, um welchen sich in zwei verschiedenen Zuständen I und II, wie sie im folgenden noch beschrieben werden, eine Raumladungszone mit unterschiedlicher Ausdehnung ausbildet, wie es durch I bzw. II angezeigt ist. Während der jeweils eine Anschluss der Schalter 22a wie in Fig. auf Masse geschaltet ist, ist der andere Anschluss, der durch den Schalter 22a, 22b mit dem Kondensator 20a bzw. 20b verbunden werden kann, mit jeweils einem unterschiedlichen Spannungsanschluss einer für die beiden Empfängerteilstrukturen 10a und 10b gemeinsamen gesteuerten Spannungsquelle 24 verbunden. Die Schalter 22a, 22b werden durch das Signal $S_1$ derart gesteuert, dass in dem Fall, dass das Signal $S_1$ einen von zwei Zuständen annimmt (durchgezogene Linie), die Spannungsquelle 24 zwischen die Kondensatoren 20a bzw. 20b geschaltet ist, um eine Spannungsdifferenz zwischen denselben anzulegen, und in dem anderen der zwei möglichen Zustände (gestrichelte Linie) jeweils eine Elektrode beider Kondensatoren 20a bzw. 20b auf Masse schalten. Die Schalter 16a und 16b werden ebenfalls gleichsinnig durch das Reset-Signal gesteuert, derart, dass in einem Zustand des Reset-Signals beide Schalter offen und in dem anderen Zustand beide Schalter geschlossen sind. Darüber hinaus existiert ein weiterer Schalter 102, der durch ein Signal $S_2$ steuerbar ist und zwischen diejenigen Elektroden der Kondensatoren 20a und 20b geschaltet ist, welche durch die Schalter 22a, 22b entweder auf Masse schaltbar oder mit der Spannungsquelle 24 verbindbar sind.

Nachdem im vorhergehenden der Aufbau der Empfängerstruktur 100 von Fig. 3 beschrieben worden ist, wird im folgenden anhand von Fig. 4 die Funktionsweise dieser Struktur zur Integration über mehrere Belichtungszyklen beschrieben.

Fig. 4 zeigt mehrere Zeitverläufe von Signalen, wie sie bei dem Betrieb der Empfangsstruktur 100 von Fig. 3 auftreten, auf dieselbe Art und Weise, wie es in Fig. 2 geschah. Insbesondere zeigt Fig. 4 bei 150 den Spannungsverlauf von Um, d.h. den durch die Spannungsquelle 24 erzeugten Spannungsdifferenz an den beiden Spannungsanschlüssen der Spannungsquelle 24, bei 152 den zeitlichen Verlauf der Lichtenergie an der Lichtquelle 908 mit zwei Beleuchtungsfenstern 154 und 156, bei 154 den zeitlichen Verlauf der Lichtenergie am Pixel 100, bei 156 den zeitlichen Verlauf des Reset-Signals zur Steuerung der Schalter 16a und 16b, wie es durch die Steuereinrichtung 912 erzeugt wird, bei 158 den zeitlichen Verlauf des Schalter-Steuersignals $S_2$, wie ebenfalls durch die Steuereinrichtung 912 erzeugt, bei 160 den zeitlichen Verlauf des ebenfalls durch die Steuereinrichtung 912 erzeugten Schalter-Steuersignals $S_1$, bei 162 den zeitlichen Verlauf der Spannung $U_{c2}$ über dem Kondensator 20b und bei 164 den zeitlichen Verlauf der Spannung $U_{c1}$ über dem Kondensator 20a.

Wie bei dem Ausführungsbeispiel von Fig. 1 und 2 werden zu einem Zeitpunkt 168 durch kurzzeitiges Schließen der Reset-Schalter 16a und 16b und im Wesentlichen gleichzeitiges kurzzeitiges Umschalten der Schalter 22a, 22b von der Spannungsquelle 24 auf Masse und zurück die Kondensatoren 20a und 20b zunächst auf die Versorgungsspannung $U_{dd}$ aufgeladen.

Nachdem die Reset-Schalter 16a, 16b wieder geöffnet und die Schalter 22a und 22b wieder die Spannungsquelle 24 zwischen die Kondensatoren 20a und 20b geschaltet haben, werden die Raumladungszonen der beiden Photodioden 12a und 12b abwechselnd zwischen den Bereichen bzw. Zuständen I und II hin-und hermoduliert, wodurch dieselben abwechselnd den jeweiligen Lichtschild 14a, 14b verlassen bzw. darunter verbleiben. Wie es zu sehen ist, verändern sich die Zustände der Raumladungszonen der beiden Photodioden 12a und 12b genau komplementär bzw. entgegengesetzt zueinander, so dass die Raumladungszone der Photodiode 12a ihre größte Ausdehnung aufweist, wenn die Raumladungszone der Photodiode 12b ihre geringste Ausdehnung aufweist, nämlich im Zustand II. Im Zustand I ist dies genau umgekehrt. Die jeweiligen Zustände sind in der Figur 4 bei 150 mit den römischen Zahlen I und II angedeutet.

In Fig. 4 ist bei 186 auch noch ein exemplarisches Beispiel eines Schaltbeispiels für das Signal S3 gezeigt, mittels dessen über den Schalter 38 die gemeinsame Guardstruktur 36 angesteuert wird. Die Wirkungen sind dieselben wie in Fig. 2 beschrieben.

Physikalisch äußert sich die vorbeschriebene Modulation der Raumladungszone in einer kontinuierlichen Schwankung der Spannungen $U_{k1}$ bzw. $U_{k2}$ an den Knoten 10a bzw. 10b. Macht man für die Knoten Spannungen $U_{k1}$ und $U_{k2}$ den analytischen Ansatz $U_{k1} = U_= + \Delta U$ bzw. $U_{k2} = U_= - \Delta U$ mit einem variablen Spannungswert $\Delta U$, so liefert die Differenz aus $U_{k1}$ und $U_{k2}$ eine Differenzspannung $U_{diff} = U_{k1} - U_{k2} = 2\,\Delta U$, wie sie durch einen Differenzverstärker erhalten werden würde, an dessen nicht-invertierenden Eingang das Ausgangssignal $U_{out1}$ und an dessen invertierenden Eingang das Ausgangssignal $U_{out2}$ angelegt würde. Die Spannung $U_{diff}$ ist somit nur noch abhängig von der Differenzspannung $\Delta U$, welche bei dieser Struktur durch die Driftladungen gegeben ist. Durch Modulation von $U_m$ lässt sich die Empfängerstruktur 100 so betreiben, dass $U_{diff}$ nur Anteile des gepulsten reflektierten Lichtes, welches das Nutzsignal, nämlich den Abstandswert, repräsentiert, enthält. Gleichzeitig werden durch die Differenzbildung Offseteffekte unterdrückt und der Nutzsignalhub verdoppelt.

Der Verdeutlichung dieser Zusammenhänge soll die folgende mathematische Betrachtung anhand der in Fig. 3 gezeigten Pixelstruktur 100 in Verbindung mit den in Fig. 4 gezeigten Zeitverläufen der relevanten Signale dienen.

Ein Maschenumlauf von Knoten 17a über 17b zurück zu Knoten 17a liefert:

$$U_{c1} + U_m - U_{c2} = U_{out1} - U_{out2} \qquad \text{Gl. 2}$$

Im Reset-Zeitpunkt 68, also zu Beginn einer Akquisition der N Belichtungszyklen, gilt:

$$U_{c1} = U_{c2} = U_{dd} \qquad \text{Gl. 3}$$

Für die Spannungsverläufe an den Speicherkondensatoren 20a bzw. 20b gilt somit:

$$U_{c1} = U_{dd} - \frac{I_{ph1} \cdot T_{int}}{C_s}, \qquad U_{c2} = U_{dd} - \frac{I_{ph2} \cdot T_{int}}{C_s} \qquad \text{Gl. 4}$$

wobei $I_{ph1}$ den fließenden Photostrom der Photodiode 12a und $I_{ph2}$ den fließenden Photostrom der Photodiode 12b bezeichnet und sich, wie im folgenden noch näher erörtert, in der Zeit verändert, je nach einfallenden reflektierten Lichtimpulsen und sich je nach Um aus entweder Drift- und Diffusionsphotostrom zusammensetzt oder nur den Diffusionsphotostrom umfasst. $T_{int}$ bezeichnet die Zeitdauer, in der der durch das einfallende licht erzeugte Photostrom zu einer Entladung des entsprechenden Kondensators führt, wobei zu beachten ist, dass Gleichung 4 lediglich für kurze Zeiträume gilt, da ja der Photostrom variabel ist, und ansonsten differentiell geschrieben wird. Für das modulierte Signal $U_m\,(t)$ gilt allgemein:

$$U_m(t) = U_= + U_{mod}(t) \qquad \text{Gl. 5}$$

und in dem vorliegenden Ausführungsbeispiel einer sinusförmigen Modulation $U_m\,(t) = U_= + U_{Amplitude} * \sin(\pi\,t/T)$. Dieser Rechenansatz ist freilich eine Vereinfachung, da für den Fall des 2-Photodioden-Pixels, wie hier geschildert, natürlich dasselbe gilt wie das bezüglich der Fig. 1 und 2 in Hinblick auf den duty-cycle des Lasers und des Modulationssignals Gesagte.

Einsetzen von Gleichung 4 und 5 in 2 liefert

$$U_= + U_{mod}(t) + \frac{T_{int}}{C_s} \cdot \left(I_{ph2} - I_{ph1}\right) = U_{out1} - U_{out2} \quad \text{Gl. 6}$$

Zu den Zeiten $(n+m)\,T$, mit $m = 1 \ldots N$ und $n \in |N$, gilt somit unter Berücksichtigung der sinusförmigen Modulation:

$$U_{out1} - U_{out2} = U_= + \frac{T_{int}}{C_s} \cdot \left(I_{ph2} - I_{ph1}\right) \quad \text{Gl. 7}$$

wobei die Photoströme $I_{ph2}$ und $I_{ph1}$ der beiden Photodioden 12a, 12b, wie oben erwähnt, Variablen der Zeit sind. Der modulierte Anteil $U_{mod}$ ist zu diesen Zeitpunkten Null.

Für die Photoströme der beiden Photodioden 12a und 12b gelten ähnliche Überlegungen, wie sie Bezug nehmend auf Fig. 2 angestellt wurden, wobei zu beachten ist, dass sich vorliegend die Zustände I bzw. II erhöhter und verringerter Empfindlichkeit der beiden Photodioden 12a und 12b genau entgegengesetzt zueinander abwechseln. Aufgrund der Wechselspannung durch die Spannungsquelle 24 wird der zum Zeitpunkt 168 auf das Potential $U_{dd}$ aufgeladene Kondensator 20a in Zeiten 172, 174 des Empfindlichkeitszustands II, da $U_m$ größer $U_=$ ist, und des Fehlens eines ankommenden Lichtpulses nur durch aufgrund von Hintergrundlicht erzeugten Diffusionsstrom entladen, während zur gleichen Zeit der Kondensator 20b durch Diffusions- und Driftphotostrom entladen wird, wie er durch das Hintergrundlicht erzeugt wird. In Zeiten 176, 178, da der Zustand I vorliegt, also Um kleiner $U_=$ ist, und kein reflektierter Laserpuls einfällt, wird der Kondensator 20a durch sowohl Diffusions- als auch Driftphotostrom in der Photodiode 12a entladen, wie er durch das Hintergrundlicht erzeugt wird, während der Kondensator 20b nur durch in der Photodiode 12b durch das Hintergrundlicht erzeugten Diffusionsphotostrom entladen wird. In Zeiten 180, 182, da das die eigentliche Information übertragende reflektierte Licht während des Zustandes I einfällt, wird folglich der Kondensator 20a von durch sowohl reflektierten Lichtpulsen als auch Hintergrundlicht erzeugtem Drift- und Diffusionsphotostrom entladen, während hingegen die Photodiode 12b mit verringerter Empfindlichkeit Hintergrundlicht und Nutzsignal lediglich in Diffusionsstrom umsetzt und hiermit den Kondensator 20b entlädt. In den übrigen Zeiten 184 setzt die Photodiode 12b das nacheilende, in die Zustände II hineinragende Ende 186 der reflektierten Lichtpulse 188, 190 in sowohl Diffusions- als auch Driftphotostrom um und entlädt hiermit den Kondensator 20b, während die Photodiode 12a Nutzsignal und Hintergrundlichtsignal lediglich in Diffusionsphotostrom umsetzt und mit demselben den Kondensator 20a entlädt.

Unter der vereinfachenden Annahme, die Zustandsänderungen erfolgten abrupt zwischen den Zuständen I und II und der Diffusionsphotostrom der Photodioden 12a und 12b sei in dem Zustand I in etwa gleich zu dem Diffusionsphotostrom im Zustand II bei gleichem Lichteinfall, gilt unter Beachtung obiger Überlegungen für die Photoströme $I_{ph1}$ in der Photodiode 12a und $I_{ph2}$ in der Photodiode 12b in den Zuständen I und II:

$$
\begin{aligned}
&\text{Zustand I} \rightarrow U_m < U_= : \\
&\qquad I_{ph1} = I_{diff} \qquad \text{(nur Diffusionsphotostrom)} \\
&\qquad \wedge\, I_{ph2} = I_{diff} + I_{drift} \text{ (Diffusions} - \text{plus Driftphotostrom)} \\
&\text{Zustand II} \rightarrow U_m > U_= : \\
&\qquad I_{ph1} = I_{diff} + I_{drift} \text{ (Diffusions} - \text{plus Driftphotostrom)} \\
&\qquad \wedge\, I_{ph2} = I_{diff} \qquad \text{(nur Diffusionsphotostrom)}
\end{aligned}
$$

$$\text{Gl. 8}$$

wobei $T_{int}$ allgemein die Integrationszeitdauer angibt.

Damit gilt für die Änderung $\delta\Delta U_I$ bzw. $\delta\Delta U_{II}$ der Differenzspannung $\Delta U_I$ bzw. $\Delta U_{II}$ zwischen zwei unmittelbar aufeinanderfolgenden Zeitpunkten $(n+m)\,T$, jeweils unmittelbar vor einem Zustand I bzw. II und danach:

$$\text{Zustand I}: \quad \delta\Delta U_I = +\frac{T_{int}}{C_s} \cdot I_{drift}$$

$$\text{Zustand II}: \quad \delta\Delta U_{II} = -\frac{T_{int}}{C_s} \cdot I_{drift} \qquad \text{Gl. 9}$$

Folglich ist der Einfluss des Diffusionsstroms aufgrund der kombinierten und entgegengesetzten betriebenen Photodioden 12a, 12b unter Verwendung dieses Werts als Ausgangssignal, nämlich der Differenz von $U_{out1}$ und $U_{out2}$, eliminiert worden.

Aufgrund der abstandsabhängigen Laufzeit $T_L$ der reflektierten Laserpulse 188, 190 sind die in den Zuständen bzw. Bereichen I bzw. II aufakkumlierten Photoladungen jeweils verschieden. Für die Photoströme gilt

$$I_{drift} = I_{ph,drift} = R \cdot E \qquad \text{Gl. 10}$$

wobei R die Responsivität der jeweiligen Photodiode für Driftphotoströme, E der empfangenden Strahlungsstärke entspricht und der Index ph die Abhängigkeit des Photostromes von der jeweiligen Photodiode bzw. dem jeweiligen Pixel wiederspiegelt.

Die empfangene Bestrahlungsstärke teilt sich auf in den Hintergrundlichtanteil $E_H$ und Laserlichtanteil $E_L$. Eine Fallunterscheidung zu den Zeitpunkten $(n + m)\,T$ einer Akquisitionsperiode $2T$ führt zu

$$\text{Zustand I}: \quad \delta\Delta U_I = \frac{T_{OVL}}{C_s} \cdot R \cdot (E_H + E_L) + \frac{T_L}{C_s} \cdot R \cdot E_H$$

$$\text{Zustand II}: \quad \delta\Delta U_{II} = \frac{T_L}{C_s} \cdot R \cdot (E_H + E_L) - \frac{T_{OVL}}{C_s} \cdot R \cdot E_H \qquad \text{Gl. 11}$$

Die in den Zeiträumen I und II akquirierten Differenzspannungen bzw. Ladungen ergeben nach jeder Periode der Dauer T eine Änderung der Differenzspannung $U_{out1}$ - $U_{out2}$ zwischen zwei Zeitpunkten $(m+n)T$ und $(m+n+2)T$ von

$$\delta\Delta U_I + \delta\Delta U_{II} = \frac{R}{C_s} \cdot (T_{OVL} - T_L) \cdot E_L \qquad \text{Gl. 12}$$

Nach N Belichtungspulsen 188, 190 der Gesamtzeitdauer $2NT$ ergibt sich somit der auswertende Wert $U_{out1}$ - $U_{out2}$ von

$$\Delta U_{Laser} = \sum_{i=1}^{N} (\Delta U_I + \Delta U_{II})_i \underset{E_L, E_H = const.}{=} U_= + N\frac{R}{C_s} \cdot (T_{OVL} - T_L) \cdot E_L$$

$$\text{Gl. 13}$$

wobei angenommen wurde, dass Hintergrundlicht, Objektposition und Beleuchtungsstärke während der Beleuchtungsphasen konstant bleiben.

Nach einer Zeitdauer von $2NT$ wird somit kurz vor dem nächsten, auf den Zeitpunkt 168 folgenden Reset-Zeitpunkt 192 kurz davor bei einem Zeitpunkt 194 das Signal $S_2$ derart aktiviert, dass der Schalter 102 geschlossen wird, wobei zu diesem Zeitpunkt, da der Schalter 102 geschlossen ist, die Differenz aus den Spannungswerten $\Delta U_{Laser}$ ausgelesen und danach der um $U_=$ korrigierte Wert $\Delta U_{Abstand} = \Delta U_{Laser} - U_=$ ausgewertet wird. Für dieses ausgewertete Signal, welche die Information über die Abstandskomponente beinhaltet, gilt dann unter Berücksichtigung, dass die Zeitdauer der Überlappung zwischen dem Zeitfenster des Zustands I und des Beleuchtungsfensters 154 bzw. 156, nämlich $T_{OVL}$, plus der Laufzeitdauer $T_L$ der Periodendauer T entspricht, d.h. $T = T_L + T_{OVL}$:

$$\Delta U_{Abstand} = \frac{R}{C_s} \cdot N \cdot \left(T - 2T_L\right) \cdot E_L \qquad \text{Gl. 14}$$

Im Vergleich zu dem vorhergehenden Ausführungsbeispiel ist das Abstandsignal somit nur noch von dem Nutzsignal, nämlich den reflektierten Lichtpulsen abhängig, während der Einfluss des Hintergrundlichtes bereits während der modulierten Signalakquisition kompensiert wird. Das Abstandsignal steht nun mit dem Faktor N verstärkt zur Verfügung, ohne durch ein ständiges Wiederaufladen des Akquisitionskondensators einem zusätzlichen Rauschen ausgesetzt zu sein. Das Reset-Signal musste nur einmal pro Integrationszyklus der Zeitdauer 2NT aktiviert bzw. die Reset-Schalter 16a und 16b nur einmal in dieser Zeitdauer geschlossen werden. Das Rauschen wird im Vergleich zu den oben erwähnten Lösungen um den Faktor N verbessert.

Zu beachten ist, dass hier der in der Realität viel niedrigere duty-cycle des Lasers von ca. 1% vernachlässigt wurde. In der Realität können zur Angleichung des in der Realität erhaltenen S/R-Verhältnis an den theoretisch ermittelten Wert, die oben erwähnten Guard-Strukturen usw. verwendet werden.

Nur der Vollständigkeit halber sei an dieser Stelle darauf hingewiesen, dass es ferner möglich wäre, die Differenz $U_{out1}^- - U_{out2}$ der Ausgangssignale auch zu jedem Zeitpunkt (n+m)T und alle Ergebnisse, beispielsweise in digitalem Format, aufzuaddieren. Der erhaltene Wert betrüge

$$\Delta U_{Laser} = 2NU_= + N\frac{R}{C_s} \cdot \left(T_{OVL} - T_L\right) \cdot E_L \qquad \text{Gl. 15}$$

und ergäbe bei entsprechender Korrektur ein auszuwertendes Signal wie in Gl. 14.

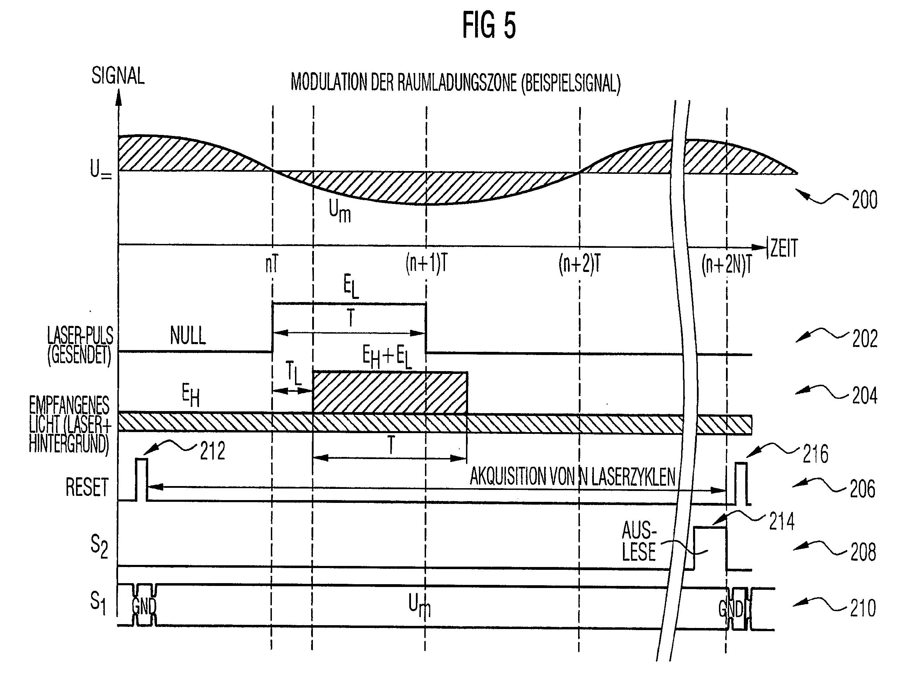

Im folgenden wird nun Bezug nehmend auf Fig. 5 ein Steuermodus der Steuereinrichtung 912 beschrieben, in welchem die Steuereinrichtung 912 die Pixel und die Lichtquelle derart steuert, dass ein Korrekturbild zu dem im vorergehenden bezugnehmend auf Fig. 4 beschriebenen, im folgenden als Aufnahmemodus bezeichneten Abstandbild ($U_{Abstand}$) erhalten wird. Insbesondere steuert die Steuereinrichtung 912 die Pixelstruktur von Fig. 3 in dem Korrekturmodus derart an, dass Informationen über die Reflektanzen der Objektpunkte bzw. des dem Pixel entsprechenden Objektpunkts ermittelt werden, der auf dieselbe abgebildet wird. Dieser Korrekturmodus wechselt sich beispielsweise mit dem oben beschriebenen Aufnahmemodus ab und trägt dem Umstand Rechnung, dass der Grad, mit dem die Kondensatoren der Empfängerstruktur entladen werden, nicht nur von der Laufzeitdifferenz bzw. dem Grad an Überlappung zwischen Beleuchtungs- und Belichtungszeitfenstern sondern auch von der Reflektanz r bzw. dem Bruchteil an reflektiertem gepulsten Licht abhängt und somit eine Rückrechnung aus dem im Abstandsmodus ermittelten Abstandsbild verfälscht wäre.

Die reflektierte Lichtmenge ist also $r*E_L$ anstatt einfach $E_L$. Es gilt anstelle von Gleichung 13 folglich

$$\Delta U_{Abstand} = \frac{R}{C_s} \cdot N \cdot \left(T_{OVL} - T_L\right) \cdot r \cdot E_L \qquad \text{Gl. 16}$$

In diesem Korrekturzyklus steuert die Steuereinrichtung 912 die Lichtquelle 908 derart an, dass dieselbe Lichtpulse 910 derselben Lichtdauer, nämlich T, ausstrahlt, aber mit einer doppelten Wiederholzeitdauer, nämlich 4T anstatt 2T (duty-cycle von 25%). Ferner wird die Wiederholfrequenz der Wechselspannung durch die Stromquelle 24 auf eine Widerholzeitdauer von T halbiert (duty-cylce immer noch 50%). Widerum wird auf die vereinfachte Darstellung und den in der Realitit bis jetzt weitaus geringeren möglichen Laser-/Modulations-duty-cycle hingewiesen. Ohne weiteres sind die folgenden Betrachtung jedoch auch auf diese Fälle übertragbar.

In Fig. 5 sind untereinander bei 200 ein exemplarischer Zeitverlauf der Wechselspannung Um, bei 202 ein exemplarischer Zeitverlauf der Lichtenergie an der Lichtquelle 908, bei 204 ein exemplarischer, sich ergebender Zeitverlauf der Lichtenergie am Ort der Empfängerstruktur 100, bei 206 ein exemplarischer Zeitverlauf des Reset-Signals, bei 208 ein exemplarischer Zeitverlauf des $S_2$-Signals und bei 210 ein exemplarischer Zeitverlauf des $S_1$-Signals gezeigt. Wie es zu sehen ist, überlappen die reflektierten Lichtpulse zeitlich gesehen vollständig mit den Zuständen I, da $U_m < U_=$. Zu den Zuständen II treffen keine reflektierten Lichtpulse ein.

Ein Korrekturmodus startet wie die oben Bezug nehmend auf Fig. 2 und 4 beschriebenen Akquisitionszyklen im Aufnahmemodus jeweils mit einem Reset-Zeitpunkt 212, da die Reset-Schalter 16a, 16b kurzzeitig geschlossen und die Schalter 22a, 22b kurzzeitig auf Masse geschaltet werden. Nach N erfolgten Belichtungspulsen werden dann zu einem Zeitpunkt 214 vor einem nächsten Reset-Zeitpunkt 216 die Werte $U_{out1}$ und $U_{out2}$ ausgelesen und die Differenz der beiden Werte als Maß für die Reflektanz verwendet, wobei sich für die zum Zeitpunkt 214 ausgelesene Differenz ergibt

$$\Delta U_{Korrektur} = \frac{R}{C_s} \cdot N \cdot T \cdot r \cdot E_L \qquad Gl. \ 17$$

Diese die Reflektanz angebende Messung kann nun verwendet werden, um zusammen mit dem in dem Bezug nehmend auf Fig. 4 beschriebenen Akquisitionszyklus erfassten Wert in G1 14 durch Quotientenbildung ein Maß $d_{comp}$ für den Abstand eines Szenenbildpunkten von der Erfassungsstruktur, auf die derselbe abgebildet wird, zu erhalten, der proportional zu Abstand $d_{real}$ zum auf das Pixel abgebildeten Objektpunkt ist:

$$d_{comp} = \frac{\Delta U_{Abstand} - \Delta U_{Korrektur}}{\Delta U_{Korrektur}} = \frac{2T_L}{T} \propto 2d_{real} \qquad Gl. \ 18$$

Die hier beschriebene Methode ist lediglich exemplarisch. Es können auch andere Vorgehensweisen zur Gewinnung des Abstandsmaßes führen. Zum Beispiel kann man unter Ausnutzung der Möglichkeit der Auslese des Zwischenergebnisses $U_{out1} - U_{out2}$ zu den Zeitpunkten $(n+m)T$ alternierend mit T, 3T, 5T ... $(2m + 1 > N)T$ pulsen (Lichtquelle 906 eingeschaltet), mit 2T, 4T, ...., $(2m < N)T$ den Hintergrundwert auslesen (Lichtquelle 906 ausgeschaltet), direkt zu den Zeitpunkten 2T, 4T, ..., $(2m < N)T$ die Reflektanzkompensation vornehmen und die reflektanzkompensierten Werte auslesen und akkumulieren. Der Vorteil läge in einer besseren Korrelation der Laser- und Hintergrundanteile aufgrund er größeren zeitlichen Nähe der zueinander in Beziehung gesetzten Messwerte.

Es ist festzuhalten, dass erst die hier beschriebene Architektur des differentiellen Photomodulators die Möglichkeit eröffnet, ein weitgehend störeinflussfreies und gleichzeitig rauscharmes Abstandsmaß zu gewinnen.

Über den hier gezeigten differentiellen Photomodulator von Fig. 3-5 hinausgehend sind weitaus komplexere Architekturen, die sehr viel mehr Pixel und ein komplizierteres Modulationsschema verwenden, möglich.

Die gezeigten Ausführungsbeispiele sind fast beliebig erweiterbar. Durch Integration von n Einzel-Photonenmodulatoren wie in Fig. 1 lassen sich n-Phasen-Dekoderarchitekturen aufbauen. Ebenso lässt sich ein Photonenmodulator nach Fig. 1 oder 3 in beliebig matrizierter Form anordnen. Um die Komplexität des Pixels zu reduzieren du dementsprechend hohe Füllfaktoren zu erzielen, würde beispielsweise ein zusätzlicher Schalter an Knoten 17 (Fig. 1) vorgesehen werden, der die Photodiode PD von der übrigen Schaltung trennt. Dieser Schalter ist optional. Jeweils nach N*T Akquisitionszyklen erzeugt er zeilenweise beispielsweise ein "high"- bzw. logisch hohes Signal zeitgleich mit S3 (Fig. 2). Aus Gründen der Übersichtlichkeit ist er in den Abbildungen nicht gezeigt.

Auch lassen sich die vorbeschriebenen 3D-Vermessungeverfahren, anhand denen die Ausführungsbeispiele für Pixelstrukturen bzw. Photonenmodulatoren beschrieben worden sind, auch mit kontinuierlichem - nicht gepulsten - Licht verwirklichen.

In Anwendungsgebieten fern der 3D-Abstandsmessung ist der Photonenmodulator ebenfalls vorteilhaft verwendbar, wie z.B. als Standard-Bildaufnahme mit CCD-/CMOS-Bildsensoren zur Erhöhung der Genauigkeit der Erfassung der Helligkeit/Belichtung der einzelnen Pixel oder als Sensor zur Erfassung des Brechungsindexes einer Probensubstanz in einem Behälter fester Dicke, da der Brechungsindex die optische Weglänge bestimmt, die sich wie oben der Abstand ermitteln ließe. Auch zur Demodulation von Mikrowellen/Radiosignalen kann der Photonenmodulator verwendet werden. Dann fungiert er als Demodulationseinheit für elektromagnetische Wellen bei entsprechend höheren Taktraten und Verwendung geeigneter Technologien. Die Anwendungsmöglichkeiten sind vielfältig und die Erfindung überall dort vorteilhaft, wo die Erfassung elektromagnetischer Strahlung über einen Erfassungszeitraum hinweg jedoch mit variierender Empfindlichkeit von Nöten ist.

Insbesondere ist die Erfindung zur Erfassung periodisch modulierter elektromagnetischer Strahlung vorteilhaft, wenn die erfasste Strahlungsstärke hauptsächlich nur in periodisch wiederkehrenden, zeitlich beabstandeten Integrationszeitdauern akkumuliert werden soll. Bei im wesentlicher gleicher Periodizität kann dann aus dem Akkumulationsergebnis auf eine Phasendifferenz zwischen Strahlung und Integrationszeitdauern rückgeschlossen werden und hieraus wiederum auf weitere, oder auch unmittelbar, auf andere Größen, wie z.B. eine optische Weglänge oder den Abstand, wie es in den obigen Ausführungsbeispielen der Fall war. Dabei ist die vorliegende Erfindung wie im vorhergehenden erwähnt insbesondere bei der Integration über mehrere Integrationszeitdauern hinweg vorteilhaft, da der hieraus entstehende Vorteil des besseren S/R-Verhältnisses nicht durch durch zwischenzeitliche Rücksetzvorgänge des die Integration vornehmenden Energiespeichers, im obigen Fall der Kapazität, bewirkte Rauschanteile geschmälert wird. Es wird jedoch darauf hingewiesen, dass auch ein Auslesen des Energiespeichers jederzeit zwischen zwei Rücksetzvorgängen möglich wäre, wie z.B. nach jeder Integrationszeitdauer. Auf diese Weise kann dann eine Kamera mit verbessertem S/R-Verhältnis erhalten werden, da nicht bei jeder Bildaufnahme Rauschanteile durch Rücksetzvorgänge entstehen.

Die vorhergehenden Ausführungsbeispiele liefern somit ein neuartiges Prinzip zur Photonenerfassung durch Modulation der Effizienz des Signalaufnehmers und genauer durch Modulation des Photoempfängers synchron mit einem Bestrahlungssignal. Guardstrukturen um jeden Photoempfänger, die in der Lage sind, saugen Störladungen, welche durch in der Laser-Erholzeit akkumuliertes Hintergrundlicht entstehen, ab, so dass der Einfluss des hintergrundlichtes, der ansonsten um einen Faktor von 1000-10000 über dem des Nutzlichtes liegen könnte, da der Laser-dutycycle in der Realität nur im Promille-Bereich liegt, deutlich abgemildert wird.

Anders ausgedrückt stellten obige Ausführungsbeispiele eine Vorrichtung zur Erfassung von Informationen über ein Objekt dar, das mit modulierter elektromagnetischer Strahlung wechselwirkt. Die Vorrichtung umfasste einen Empfänger, der abhängig von einer mit dem Objekt in Wechselwirkung getretenen modulierten elektromagnetischen Strahlung ein Ausgangssignal ausgibt, eine Einrichtung zum Variieren einer Empfindlichkeit des Empfängers, eine Einrichtung, welche den Empfänger in einen gegen störende elektromagnetische Strahlung unempfindlichen Zustand versetzt, einen Energiespeicher, der mit dem Empfänger verbunden ist, und dessen gespeicherte Energie durch das Ausgangssignal veränderbar ist, sowie eine Steuereinrichtung zum periodischen Rücksetzen des Energiespeichers auf einen vorbestimmten Referenzenergiewert und Steuern der Einrichtung zum Variieren der Empfindlichkeit derart, dass zwischen zwei aufeinanderfolgenden Rücksetzereignissen die Empfindlichkeit zu zumindest zwei voneinander getrennten Zeitdauern hoch und zwischen den zwei Zeitdauern niedrig ist, wobei ein Zustand des Energiespeichers vor einem Rücksetzereignis Informationen über das Objekt liefert.

Die Prinzipien dieser Ausführungsbeispiele sind aber auch anwendbar auf nicht photonenbasierte Sensorsignalauswertesysteme. Außerdem könnte der Lichtschild fehlen. Auch sind die obigen Ausführungsbeispiele in jedweder Technologie realisierbar, wie z.B. CMOS, BICMOS, CCD, Bipolar, SIMOX u.a.

Die als exemplarische Anwendungsumgebung beschriebene 3D-Vermessung setzt die Synchronität zwischen Lichtmodulator und Lichtquellenpulse nicht zwingend voraus sondern kann auch asynchron ausgeführt sein. Nicht-starre Phasenbeziehungen und unterschiedliche zeitliche Breiten zwischen Modulator und Strahlungsquelle sind uneingeschränkt realisierbar, d.h. nicht zueinander phasenstarre und/oder nicht gleichlange Laser/Shutterzeitfenster. Zyklusweise phasenverschobene Laser/Shutterzeitfenster, d.h. zueinander verschobene Phasenlagen pro Aquisitionszyklus, könnten beispielsweise mit Absicht durch einen geeigneten Auswertealgorithmus dazu verwendet werden, um den zu bestimmenden Abstand aus der optimalen Phasenlage bzw. aus der sich hierzu ergebenden Phasenverschiebung zu bestimmen. Das Shutter-oder das Laserfenster würde von Zyklus zu Zyklus um einen definiertes Zeitintervall verschoben werden, wobei der Auswertealgorithmus aus der Verschiebungsinformation die sich beispielsweise ergibt, bis die Phasenlage zwischen Shutter/Laserfenster Null ist, den Abstand ermitteln würde.

Ferner sind andere Ausleseschaltungen möglich als die vorgezeigte Möglichkeit aus Schalter S1, Reset-Schalter, "1"-Verstärker und Guard-Struktur.

Es ist somit anhand der obigen Ausführungsbeispiele die Entwicklung eines Detektionsprinzips sowie einer Detektorstruktur gelungen, die nur einmal zu Beginn einer Pulssequenz das Pixel bzw. den Empfänger zurücksetzt, wobei das Prinzip allgemein auf eine modulierte Signalgewinnung übertragbar ist, da es auch in Anwendungsgebieten fern der 3D Abstandsmessung verwendbar ist.

Erzeugte Verbesserungen gegenüber dem Stand der Technik durch die in den obigen Ausführungsbeispielen verdeutlichte modulierte Signalgewinnung bestehen primär hinsichtlich Erhöhung der Detektorempfindlichkeit, Verbesserung der Nutzsignalauflösung und Hintergrundlichtunterdrückung. Das hier vorgestellte System erzeugt bei gleicher Lichtmenge einen wesentlich höheren Nutzsignalhub im Detektor als dies existierende Systeme können. Somit lassen sich zukünftig gerade auch in sicherheitsrelevanten Applikationen zuverlässige Abstands- und Tiefenkartenbildaufnehmer gewinnen. Dies kommt den in der Beschreibungseinleitung erwähnten Marktsegmenten zugute.

Es soll nicht übergangen werden, dass das erfindungsgemäße Aufakkumulieren des Ausgangssignals eines Empfängers, bzw. bezogen auf die obigen Ausführungsbeispiel, des Photostroms einer Photodiode über mehr als eine Zeitdauer hoher Empfindlichkeit dazu führt, dass bei gleichem Empfänger bzw. gleicher Photodiode ein größerer Energiespeicher bzw. ein größerer Kondensator zur Verfügung stehen sollte. Vorzugsweise ist bei den obigen Ausführungsbeispielen deshalb ein Kondensator der Kapazität in dem Bereich von größer 100fF bzw. einigen 100fF mit den Photodioden direkt verbunden.

**Patentansprüche**

1. Vorrichtung zur Erfassung elektromagnetischer Strahlung (910), bei der die elektromagnetische Strahlung gepulst ist, mit

   einem Empfänger (12), der abhängig der elektromagnetischen Strahlung ein Ausgangssignal ausgibt;
   einer Einrichtung (24) zum Variieren einer Empfindlichkeit des Empfängers (12);
   einem Energiespeicher (20), der mit dem Empfänger (12) verbindbar ist, und dessen gespeicherte Energie in verbundenem Zustand gemäß dem Ausgangssignal verändert wird;
   und
   einer Steuereinrichtung (912) zum periodischen Rücksetzen des Energiespeichers (20) auf einen vorbestimmten Referenzenergiewert und Steuern der Einrichtung (24) zum Variieren der Empfindlichkeit derart, dass
   zwischen zwei aufeinanderfolgenden Rücksetzereignissen (68, 70; 168,192) die Empfindlichkeit zumindest einmal (76, 78, 80, 82; 176, 178, 180, 182) hoch und einmal niedrig ist,
   wobei das Hin- und Herschalten zwischen hoher und niedriger Empfindlichkeit mit Pulszeitdauern (60, 62; 164, 156) synchronisiert ist, an denen die elektromagnetische Strahlung abgestrahlt wird,
   wobei ein Zustand des Energiespeichers (20) auf die elektromagnetische Strahlung hin weist.

2. Vorrichtung gemäß Anspruch 1, bei der der Empfänger (12) einen Halbleiter-pn-Übergang (12) umfasst, der abhängig von der elektromagnetischen Strahlung Ladungsträger erzeugt.

3. Vorrichtung gemäß Anspruch 2, bei der die Einrichtung (24) zum Variieren eine steuerbare Spannungsquelle (24) zum Anlegen einer variablen Sperrspannung an den pn-Übergang (12) ist, wobei die Steuereinrichtung (912) ausgebildet ist, um die Spannung der Spannungsquelle (24) derart zu variieren, dass für eine hohe Empfindlichkeit die Raumladungszone eine höhere Ausdrehung (B; II) aufweist als für niedrigere Empfindlichkeit (A; I),

4. Vorrichtung gemäß Anspruch 2 oder 3, bei der der Energiespeicher (20) eine Kapazität (20) ist, die durch einen in dem pn-Übergang (12) erzeugten Photostrom aufgeladen oder entladen wird.

5. Vorrichtung gemäß Anspruch 4, bei der die Kapazität einen Kondensator (20) umfasst, der derart mit dem pn-Übergang (12) verbindbar ist, dass derselbe durch den in dem pn-Übergang (12) erzeugten Photostrom entladen wird.

6. Vorrichtung gemäß Anspruch 4 oder 5, bei der die Kapazität eine Sperrschichtkapazität des pn-Übergangs (12) umfasst, die durch den in dem pn-Übergang (12) erzeugten Photostrom aufgeladen wird.

7. Vorrichtung gemäß Anspruch 5, mit Rückbezug auf Anspruch 3, bei der der Kondensator (20) in Reihe zwischen den pn-Übergang (12) und die steuerbare Spannungsquelle (24) schaltbar ist.

8. Vorrichtung gemäß Anspruch 1, die ferner folgende Merkmale aufweist:

   einen Pendantempfänger (12b), wobei der Empfänger (12a) einen ersten pn-Übergang (12a) umfasst, der abhängig von elektromagnetischer Strahlung erste Ladungsträger erzeugt, wobei der Pendantempfänger (12b) einen zweiten pn-Übergang (12b) umfasst, der abhängig von elektromagnetischer Strahlung zweite Ladungsträger erzeugt;
   einen Pendantenergiespeicher (20b), wobei der Energiespeicher (20a) einen ersten Kondensator (20a) und der Pendantenergiespeicher (20b) einen zweiten Kondensator (20b) umfasst,

   wobei die Einrichtung (24) zum Varriieren eine steuerbare Spannungsquelle (24) zum Erzeugen einer variablen Spannungsdifferenz zwischen einem ersten Spannungsanschluss und einem zweiten Spannungsanschluss ist, und wobei der erste Kondensator (20a) zwischen den zwei aufeinanderfolgenden Rücksetzvorgängen zwischen den ersten pn-Übergang (12a) und den ersten Spannungsanschluss und der zweite Kondensator (20b) zwischen den zweiten pn-Übergang (12b) und den zweiten Spannungsanschluss geschaltet ist; und

wobei die Steuereinrichtung (912) ausgebildet ist, um den ersten Kondensator (20a) und den zweiten Kondensator (20b) gleichzeitig rückzusetzen, und um die steuerbare Spannungsquelle (24) mit einem Takt derart anzusteuern, dass in aufeinanderfolgenden Rücksetzereignissen einmal eine Raumladungszone der ersten Photodiode größer und eine Raumladungszone der zweiten Photodiode kleiner und das andere Mal die Raumladungszone der ersten Photodiode kleiner und die Raumladungszone der zweiten Photodiode größer ist.

9. Vorrichtung gemäß Ansprüche 2 bis 8, die ferner folgende Merkmale aufweist:

Einen Schild (10) zum Abschirmen der Photodiode (12) vor der mit dem Objekt (906) in Wechselwirkung getretenen Strahlung mit einer Ausdehnung einer Raumladungszone des pn-Übergang (12), die der Ausdehnung einer Raumladungszone des pn-Übergangs (12) entspricht, wenn sich derselbe in einem Zustand geringer Empfindlichkeit befindet,

10. Vorrichtung gemäß einem der Ansprüche 2 bis 9, bei dem der Empfänger einen pn-Übergang umfasst, und bei dem eine Abschirmstruktur um den pn-Übergang gebildet ist, um Störladungen in dem Empfänger aufgrund von störender elektromagnetischer Strahlung in Zeiten zwischen den Pulszeitdauern abzuleiten.

11. System zur 3D-Vermessung eines Objektes mit
einer gepulsten Lichtquelle (908) zum gepulsten Anstrahlen des Objektes (906) mit gepulster elektromagnetischer Strahlung;
einer Mehrzahl von Vorrichtungen nach Anspruch 1, deren Empfänger in einer Matrix (902) angeordnet sind, und deren Steuereinrichtung (912) ausgebildet ist, um die Synchronisation des Hin- und Herschaltens bezüglich des gepulsten Anstrahlens der gepulsten Lichtquelle durchzuführen;
einer Abbildungseinrichtung (904) zum Abbilden des Objekts auf die Matrix; und
einer Auswerteeinrichtung (912) zum Erzeugen von 3D-Informationen über das Objekt basierend auf den Zuständen des Energiespeichers der Mehrzahl von Vorrichtungen.

12. Vorrichtung nach Anspruch 11, bei der die Auswerteeinrichtung (912) ausgebildet ist, um aus den Zuständen jedes Energiespeichers (20) de Abstand von einem Punkt auf dem Objekt (906), welcher auf den Empfänger dieses Energiespeicher abgebildet wird, zu berechnen.

13. Verfahren zum Betreiben eines Empfängers zur Erfassung von gepulster elektromagnetischer Strahlung, mit folgenden Schritten:

Rücksetzen eines Energiespeichers (20), der mit einem Empfänger (12) verbindbar ist, der abhängig von der elektromagnetischen Strahlung ein Ausgangssignal ausgibt, und dessen gespeicherte Energie in verbundenem Zustand gemäß dem Ausgangssignal verändert wird;
Varrieren einer Empfindlichkeit des Empfängers (12); und
Periodisches Rücksetzen des Energiespeichers (20) auf einen vorbestimmten Referenzenergiewert und Steuern der Einrichtung (24) zum Variieren der Empfindlichkeit derart, dass zwischen zwei aufeinanderfolgenden Rücksetzereignissen (68, 70; 168, 192) die Empfindlichkeit zumindest einmal (76, 78, 80, 82; 176, 178, 180, 182) hoch und einmal niedrig ist,
uns dass das Hin- und Herschalten zwischen hoher und niedriger Empfindlichkeit mit Pulszeitdauern (60, 62; 154, 156) synchronisiert ist, an denen die elektromagnetische Strahlung abgestrahlt wird,

wobei ein Zustand des Energiespeichers (20) auf die elektromagnetische Strahlung hinweist.

## Claims

1. A device for detecting electromagnetic radiation (910), wherein the electromagnetic radiation is pulsed, having
a receiver (12) which outputs an output signal in dependence on the electromagnetic radiation;
a means (24) for varying a sensitivity of the receiver (12);
an energy store (20) which is connectable to the receiver (12) and whose stored energy is changed, in a connected state, in accordance with the output signal; and
a control means (912) for periodically resetting the energy store (20) to a predetermined reference energy value, and for controlling the means (24) for varying the sensitivity such that
between two successive resetting events (68, 70; 168, 192), the sensitivity is high at least once (76, 78, 80, 82; 176, 178, 180, 182) and is low once,
the switching back and forth between high and low sensitivity being synchronized with pulse time periods (60, 62; 154, 156) during which the electromagnetic radiation is emitted, a state of the energy store (20) giving an indication of the electromagnetic radiation.

2. The device as claimed in claim 1, wherein the receiver (12) comprises a semiconductor p-n junction (12) generating charge carriers in dependence on the electromagnetic radiation.

3. The device as claimed in claim 2, wherein the means (24) for varying is a controllable voltage source (24) for applying a variable reverse bias voltage to the p-n junction (12), the control means (912) being configured to vary the voltage of the voltage source (24) such that the space-charge region has a higher expansion (B; II) for a high sensitivity than for lower sensitivity (A; I).

4. The device as claimed in claim 2 or 3, wherein the energy store (20) is a capacitance (20) which is charged or discharged by a photocurrent generated in the p-n junction (12).

5. The device as claimed in claim 4, wherein the capacitance comprises a capacitor (20) which is connectable to the p-n junction (12) such that same is discharged by the photocurrent generated in the p-n junction (12).

6. The device as claimed in claim 4 or 5, wherein the capacitance comprises a depletion-layer capacitance of the p-n junction (12) which is charged by the photocurrent generated in the pn transition (12).

7. The device as claimed in claim 5, while referring back to claim 3, wherein the capacitor (20) may be connected in series between the p-n junction (12) and the controllable voltage source (24).

8. The device as claimed in claim 1, further having the following features:

   a counterpart receiver (12b), the receiver (12a) comprising a first p-n junction (12a) which generates first charge carriers in dependence on electromagnetic radiation, the counterpart receiver (12b) comprising a second p-n junction (12b) which generates second charge carriers in dependence on the electromagnetic radiation;
   a counterpart energy store (20b), the energy store (20a) comprising a first capacitor (20a), and the counterpart energy store (20b) comprising a second capacitor (20b),
   the means (24) for varying being a controllable voltage source (24) for generating a variable voltage difference between a first voltage terminal and a second voltage terminal, and the first capacitor (20a) being connected, between the two successive resetting operations, between the first p-n junction (12a) and the first voltage terminal, and the second capacitor (20b) being connected between the second p-n junction (12b) and the second voltage terminal; and
   the control means (912) being configured to simultaneously reset the first capacitor (20a) and the second capacitor (20b) and to control the controllable voltage source (24) with a clocking signal such that in successive resetting events, at one time a space-charge region of the first photodiode is larger and a space-charge region of the second photodiode is smaller, and the other time, the space-charge region of the first photodiode is smaller, and the space-charge region of the second photodiode is larger.

9. The device as claimed in claims 2 to 8, further having the following features:

   a shield (10) for shielding the photodiode (12) from the radiation having started interacting with the object (906) and
   having an expansion of a space-charge region of the p-n junction (12) which corresponds to the expansion of a space-charge region of the p-n junction (12) when same is in a state of low sensitivity.

10. The device as claimed in any of claims 2 to 9, wherein the receiver comprises a p-n junction and wherein a shielding structure is formed around the p-n junction to drain off spurious charges in the receiver caused by interfering electromagnetic radiation in times between the pulse time durations.

11. A system for 3D-measuring of an object, having:

   a pulsed light source (908) for illuminating the object (906) in a pulsed manner with pulsed electromagnetic radiation;

a plurality of devices as claimed in claim 1, the receivers of which are arranged in a matrix (902), and the control means (912) of which is configured to perform the synchronization of toggling with regard to the pulsed illumination of the pulsed light source;
an imaging means (904) for imaging the object onto the matrix; and
an evaluation means (912) for producing 3D information about the object on the basis of the states of the energy store of the plurality of devices.

**12.** The device as claimed in claim 11, wherein the evaluation means (912) is configured to calculate, from the states of each energy store (20), the distance from a point on the object (906) which is imaged onto the receiver of this energy store.

**13.** A method for operating a receiver for detecting pulsed electromagnetic radiation, having the following steps:

resetting an energy store (20) which is connectable to a receiver (12), which outputs an output signal in dependence on the electromagnetic radiation, and the stored energy of which is changed, in a connected state, in accordance with the output signal;
varying a sensitivity of the receiver (12); and
periodically resetting the energy store (20) to a predetermined reference energy value, and controlling the means (24) for varying the sensitivity such that
between two successive resetting events (68, 70; 168, 192), the sensitivity is high at least once (76, 78, 80, 82; 176, 178, 180, 182) and is low at least once,
and the switching back and forth between high and low sensitivity is synchronized with pulse time periods (60, 62; 154, 156) during which the electromagnetic radiation is emitted,
a state of the energy store (20) giving an indication of the electromagnetic radiation.

## Revendications

**1.** Dispositif pour la détection d'un rayonnement électromagnétique (910), dans lequel le rayonnement électromagnétique est pulsé, possédant
un récepteur (12) qui émet un signal de sortie en fonction du rayonnement électromagnétique ;
un dispositif (24) pour la variation d'une sensibilité du récepteur (12) ;
un accumulateur d'énergie (20) pouvant être connecté au récepteur (12) et dont l'énergie accumulée est modifiée en état connecté en fonction du signal de sortie ;
et
un dispositif de commande (912) pour la réinitialisation périodique de l'accumulateur d'énergie (20) sur une valeur d'énergie de référence prédéfinie et la commande du dispositif (24) pour la variation de la sensibilité de telle façon que la sensibilité soit au moins une fois (76, 78, 80, 82 ; 176, 178, 180, 182) élevée et une fois faible entre deux événements de réinitialisation consécutifs (68, 70 ; 168, 192),
où le basculement entre une sensibilité élevée et faible est synchronisé à l'aide de périodes d'impulsions (60, 62 ; 154, 156) sur lesquelles le rayonnement électromagnétique irradie,
où un état de l'accumulateur d'énergie (20) donne des indications sur le rayonnement électromagnétique.

**2.** Dispositif selon la revendication 1, dans lequel le récepteur (12) comprend un passage pn semi-conducteur générant des porteurs de charge en fonction du rayonnement électromagnétique.

**3.** Dispositif selon la revendication 2, dans lequel le dispositif (24) pour la variation est une source de tension (24) commandable pour l'établissement d'une tension inverse variable au niveau de la jonction p-n (12), où le dispositif de commande (912) est conçu de sorte à varier la tension de la source de tension (24) de telle façon que pour une sensibilité élevée, la région de charge spatiale possède une étendue plus élevée (B; II) que pour une sensibilité plus faible (A; I).

**4.** Dispositif selon la revendication 2 ou 3, dans lequel l'accumulateur d'énergie (20) est une capacité (20) chargée ou déchargée via un courant photo-électrique généré dans la jonction p-n (12).

**5.** Dispositif selon la revendication 4, dans lequel la capacité comprend un condensateur (20) pouvant être relié à la jonction p-n (12) de telle façon que ledit condensateur soit déchargé via le courant photo-électrique généré dans la jonction p-n (12).

**6.** Dispositif selon la revendication 4 ou 5, dans lequel la capacité comprend une capacité de la zone de déplétion de la jonction p-n (12), laquelle est chargée via le courant photo-électrique généré dans le passage pn (12).

**7.** Dispositif selon la revendication 5, avec référence à la revendication 3, dans lequel le condensateur (20) est commutable en ligne entre la jonction p-n (12) et la source de tension (24) commandable.

**8.** Dispositif selon la revendication 1, possédant en outre les caractéristiques suivantes :

un récepteur associé (12b), où le récepteur (12a) comprend une première jonction p-n (12a) générant des premiers porteurs de charge en fonction d'un rayonnement électromagnétique, où le récepteur associé (12b) comprend une deuxième la jonction p-n (12b) générant des deuxièmes porteurs de charge en fonction d'un rayonnement électromagnétique ;
un accumulateur d'énergie associé (20b), où l'accumulateur d'énergie (20a) comprend un premier condensateur (20a) et l'accumulateur d'énergie associé (20b) comprend un deuxième condensateur (20b),

où le dispositif (24) pour la variation est une source de tension (24) commandable pour la génération d'une différence de tension variable entre un premier circuit de tension et un deuxième circuit de tension, et où le premier condensateur (20a) est commuté entre les deux processus de réinitialisation consécutifs entre la première jonction p-n (12a) et premier circuit de tension et le deuxième condensateur (20b) est commuté entre la deuxième jonction p-n (12b) et le deuxième circuit de tension ; et
où le dispositif de commande (912) est conçu de sorte à réinitialiser simultanément le premier condensateur (20a) et le deuxième condensateur (20b), et à commander la source de tension (24) commandable à l'aide d'une horloge de telle façon que dans des événements de réinitialisation consécutifs, une région de charge spatiale de la première photodiode soit plus grande et une région de charge spatiale de la deuxième photodiode soit plus petite une fois et que la région de charge spatiale de la première photodiode soit plus petite et la région de charge spatiale de la deuxième photodiode soit plus grande une autre fois.

**9.** Dispositif selon les revendications 2 à 8, possédant en outre les caractéristiques suivantes :

un bouclier (10) pour l'isolement de la photodiode (12) devant le rayonnement émis en interaction avec l'objet (906) avec une extension d'une région de charge spatiale de la jonction p-n (12) correspondant à l'extension d'une région de charge spatiale de la jonction p-n (12) lorsque ce dernier se trouve dans un état de sensibilité faible.

**10.** Dispositif selon une des revendications 2 à 9, dans lequel le récepteur comprend une jonction p-n, et dans lequel une structure d'isolement est formée autour de la jonction p-n , afin d'évacuer des charges perturbatrices dans le récepteur, dues à un rayonnement électromagnétique perturbateur, aux moments situés entre les périodes d'impulsions.

**11.** Système pour la détection 3D d'un objet, possédant
une source lumineuse (908) pulsée pour l'illumination pulsée de l'objet (906) avec un rayonnement électromagnétique pulsé ;
une pluralité de dispositifs selon la revendication 1, dont les récepteurs sont disposés dans une matrice (902), et dont le dispositif de commande (912) est conçu de sorte à réaliser la synchronisation du basculement relatif à l'illumination pulsée de la source lumineuse pulsée ;
un dispositif de représentation (904) pour la représentation de l'objet sur la matrice ; et
un dispositif d'évaluation (912) pour la génération d'informations 3D relatives à l'objet en fonction des états de l'accumulateur d'énergie de la pluralité de dispositifs.

**12.** Dispositif selon la revendication 11, dans lequel le dispositif d'évaluation (912) est formé de sorte à calculer, à partir des états de chaque accumulateur d'énergie (20), l'écart d'un point sur l'objet (906), lequel point est représenté sur le récepteur de cet accumulateur d'énergie.

**13.** Procédé pour l'exploitation d'un récepteur pour la détection d'un rayonnement électromagnétique pulsé, possédant les étapes suivantes:

réinitialisation d'un accumulateur d'énergie (20) pouvant être connecté à un récepteur (12) qui émet un signal de sortie en fonction du rayonnement électromagnétique, et dont l'énergie accumulée est modifiée en état connecté en fonction du signal de sortie ;

variation d'une sensibilité du récepteur (12) ; et

réinitialisation périodique de l'accumulateur d'énergie (20) sur une valeur d'énergie de référence prédéfinie et commande du dispositif (24) pour la variation de la sensibilité de telle façon que

la sensibilité soit au moins une fois (76, 78, 80, 82 ; 176, 178, 180, 182) élevée et une fois faible entre deux événements de réinitialisation consécutifs (68, 70 ; 168, 192),

et que le basculement entre une sensibilité élevée et faible soit synchronisé à l'aide de périodes d'impulsions (60, 62 ; 154, 156) sur lesquelles le rayonnement électromagnétique irradie,

où un état de l'accumulateur d'énergie (20) donne des indications sur le rayonnement électromagnétique.

FIG 1

## FIG 2

FIG 3

LICHT

10A

10B

14A

14B

LICHTSCHILD

LICHTSCHILD

ZWISCHENSCHICHT

100

GUARDSTRUKTUR

GUARDSTRUKTUR

GUARDSTRUKTUR

GUARDSTRUKTUR

36

38

$n+$-PHOTO-KATHODE

$n+$-PHOTO-KATHODE

$W_{RLZ}=a$

$W_{RLZ}=b$

$W_{RLZ}=a$

$W_{RLZ}=b$

28A

28B

PD

PD

p-SUBSTRAT

$S_3$ $U_{dd}$

$U_{dd}$

$U_{dd}$

RESET

16A

17A

16B

17B

$C_S$

$U_{c1}$

20A

$C_S$

$U_{c2}$

20B

$U_{K1}$

$U_{K2}$

34A

18A

1

$U_{OUT1}$

34B

18B

1

$U_{OUT2}$

22A

22B

$S_1$

$S_1$

$S_2$

102

24

$U_m$

38

36

EP 1 636 610 B1

# FIG 4

# FIG 5

SIGNAL

MODULATION DER RAUMLADUNGSZONE (BEISPIELSIGNAL)

$U_=$

$U_m$

ZEIT

$nT$     $(n+1)T$     $(n+2)T$     $(n+2N)T$

$E_L$

$T$

LASER-PULS (GESENDET)    NULL

$E_H + E_L$

$T_L$

EMPFANGENES LICHT (LASER+ HINTERGRUND)    $E_H$

$T$

212

216

RESET    AKQUISITION VON N LASERZYKLEN

214

AUS- LESE

$S_2$

$S_1$    GND    $U_m$    GND

200

202

204

206

208

210

EP 1 636 610 B1

# FIG 6

908

910

906

902

904

912

# FIG 7

920

922

ABGESTRAHLTES
LICHT

PULS 1

PULS 2

t

$t_{01}$

924

$Q_1$(PULS 1)

928

926

$Q_1$(PULS 2)

930

EMPFANGENES
LICHT AN
PIXEL 1

RESET    AUSLESE

RESET    AUSLESE

t

$t_{02}$

924

$Q_2$(PULS 1)

932

926

$Q_2$(PULS 2)

934

EMPFANGENES
LICHT AN
PIXEL 2

RESET    AUSLESE

RESET    AUSLESE

t

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0233817 A

- DE 19757595 A1

**In der Beschreibung aufgeführte Nicht-Patentliteratur**

- **R. JEREMIAS ; W. BROCKHERDE ; G. DOEMENS ; B. HOSTICKA ; L. LISTL ; P. MEN-GEL.** A COMS photosensor array for 3-D imaging using pulsed laser. *Digest of Techn. Papers IEEE international Solid-State Circuits Conf. 2001,* 06. Februar 2001, 252-253

- **R. SCHWARTE et al.** *Proceedings of the SPIE, SPIE,* 1997, 245-253